(19) Europäisches Patentamt
European Patent Office
Office européen des brevets

(11) Veröffentlichungsnummer: **0 122 223**
**B1**

(12) # EUROPÄISCHE PATENTSCHRIFT

(45) Veröffentlichungstag der Patentschrift: **26.10.88**

(51) Int. Cl.⁴: **C 07 F 17/00**, G 03 C 1/68, C 08 F 2/50

(21) Anmeldenummer: **84810069.9**

(22) Anmeldetag: **06.02.84**

(54) **Metallocene und photopolymerisierbare Zusammensetzung, enthaltend diese Metallocene.**

(30) Priorität: **11.02.83 CH 784/83**

(43) Veröffentlichungstag der Anmeldung:
**17.10.84 Patentblatt 84/42**

(45) Bekanntmachung des Hinweises auf die Patenterteilung:
**26.10.88 Patentblatt 88/43**

(84) Benannte Vertragsstaaten:
**AT BE CH DE FR GB IT LI NL SE**

(56) Entgegenhaltungen:
**EP - A - 0 119 162**

**JOURNAL OF ORGANOMETALLIC CHEMISTRY, Band 10, 1967, Seiten 471-481, Elsevier Publishing Company, Amsterdam, NL; S.C. COHEN u.a.: "Perfluorophenyl derivatives of the elements XII. 2,2'-disubstituted octafluorobiphenyls"**
**JOURNAL OF THE AMERICAN CHEMICAL SOCIETY, Band 95, Nr. 19, 19. September 1973, Seiten 6263-6267, Washington, D.C., US; E. SAMUEL u.a.: "pi-Cyclopentadienyl and pi-indenyl compounds of titanium, zirconium, and hafnium containing sigma-bonded organic substituents"**
**JOURNAL OF POLYMER SCIENCE, Band 10, 1972, Seiten 2833-2840, John Wiley & Sons, New York, US; K. KAERIYAMA u.a.: "Photopolymerization with the use of titanocene dichoride as sensitizer"**

(73) Patentinhaber: **CIBA-GEIGY AG, Klybeckstrasse 141, CH-4002 Basel (CH)**

(72) Erfinder: **Riediker, Martin, Dr., Gstaltenrainweg 75, CH-4125 Riehen (CH)**
Erfinder: **Roth, Martin, Dr., Oberdorf, CH-1711 Giffers (CH)**
Erfinder: **Bühler, Niklaus, Dr., Route du Pâquier 8, CH-1723 Marly (CH)**
Erfinder: **Berger, Joseph, Dr., Sperrstrasse 40/18, CH-4057 Basel (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

Die vorliegende Erfindung betrifft Titanocene mit zumindest teilweise fluorierten aromatischen Resten, eine photopolymerisierbare Zusammensetzung aus äthylenisch ungesättigten Verbindungen, die Titanocene als Photoinitiatoren enthalten, ein mit dieser Zusammensetzung beschichtetes Substrat und ein Verfahren zur Herstellung photographischer Reliefabbildungen unter Verwendung dieses beschichteten Substrates.

Die Photolithographie hat wesentlich zur Entwicklung der Elektronik beigetragen. Zur Übertragung von Abbildungen werden hierbei strahlungsempfindliche Stoffe, die auf ein Substrat aufgebracht sind, bildmässig belichtet, wodurch sich die Löslichkeit der belichteten Anteile so verändert, dass entweder die belichteten Anteile (Positivverfahren) oder unbelichteten Anteile (Negativverfahren) mit einem geeigneten Lösungsmittel entfernt werden können. Die Substrate können danach zur Herstellung von z.B. gedruckten oder integrierten Schaltungen in bekannter Weise modifiziert werden.

Es gibt verschiedenartige lichtempfindliche Stoffe, die in dieser Resisttechnik Verwendung finden und oft auf ganz bestimmte Techniken abgestimmt sind. Eine Gruppe geeigneter Photoresists sind Verbindungen mit äthylenisch ungesättigten Doppelbindungen, die mittels geeigneter Photoinitiatoren unter Einwirkung von Strahlung photopolymerisieren.

Ein Grossteil der bekannten Initiatoren ist im Wellenlängenbereich des UV-Lichtes bis etwa 420 nm wirksam. Mittels spektraler Sensibilisierung ist es möglich, den Empfindlichkeitsbereich in den sichtbaren Bereich des Lichtes bis etwa 600 nm auszudehnen. Hierdurch wird der Einsatz von z.B. Argon- oder Kryptonlasern für die zeilenweise Bildaufzeichnung möglich.

Die bis jetzt in der Praxis verwendeten Initiatorsysteme haben den Nachteil einer ungenügenden Empfindlichkeit und/oder Lagerstabilität, wodurch man bei Verwendung von Lasern solche mit hoher Leistung verwenden muss, die teuer sind und nur eine kurze Lebensdauer haben.

In der DE-OS 27 53 889 sind z.B. Kombinationen von organischen Farbstoffen und Aminen als Photoinitiatoren für (Meth)Acrylate vorgeschlagen. Ihre Empfindlichkeit ist für eine wirtschaftliche Anwendung jedoch zu gering.

Es ist auch schon seit längerem bekannt, Dicyclopentadienyltitanocene als Photoinitiatoren für äthylenisch ungesättigte Verbindungen bei Bestrahlung mit sichtbarem Licht einzusetzen, vgl. z.B. J. of Polymer Science 10(1972), S. 2833 bis 2840 und Inorganica Chimica Acta 52 (1981), S. 197–204. Bei den verwendeten Initiatoren, Dicyclopentadienyldichlortitanocen und Dicyclopentadienyldiphenyltitanocen handelt es sich um thermisch instabile Verbindungen. Dicyclopentadienyldichlortitanocen ist zwar luftstabil, aber ungenügend lichtempfindlich. Dicyclopentadienyldiphenyltitanocen ist sehr instabil an Luft, aber ausreichend lichtempfindlich. Diese Verbindungen sind für eine praktische Anwendung nicht geeignet.

Aus Amer. Chem. Soc. 95, 6263–6267 (1973) und J. Organomet. Chem. 10, 471–481 (1967) sind unter anderem verschiedene Titanocenverbindungen bekannt, u.a. zwei davon, in denen 2 Valenzen des Titanatoms an Fluoraromaten gebunden sind. Es wird aber kein Hinweis auf eine mögliche Verwendung als Photoinitiatoren gegeben.

Photoinitiatoren für die Photopolymerisation, die gegenüber Licht-, Luft- und Wärmeeinwirkung ausreichend stabil und damit auch lagerstabil sind, die vom UV-Licht bis zum sichtbarem Licht, besonders um 500 nm, sogar in dicken Schichten wirksam sind und eine hohe Empfindlichkeit besitzen, stehen der Technik noch nicht zur Verfügung. Dies wäre aber äusserst wünschenswert, um neben den üblichen Abbildungsverfahren auch Laser mit geringerer Leistung für die Bildaufzeichnung durch Photopolymerisation einzusetzen.

Aufgabe vorliegender Erfindung ist es, solche Photoinitiatoren und photopolymerisierbare Zusammensetzungen, die solche Photoinitiatoren enthalten, bereitzustellen.

Ein Gegenstand vorliegender Erfindung sind Titanocene der Formel I′,

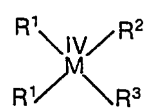

(I′)

worin

M für das vierwertige Titanatom steht,

beide $R^1$ unabhängig voneinander Cyclopentadienyl$^{\ominus}$, Indenyl$^{\ominus}$ oder

beide $R^1$ zusammen einen Rest der Formel II

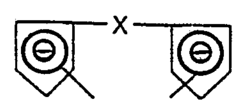

(II)

bedeuten, worin X $(CH_2)_n$ mit n = 1,2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet, wobei die Reste Cyclopentadienyl$^{\ominus}$, Indenyl$^{\ominus}$ oder der Formel II jeweils unsubstituiert oder durch lineares oder verzweigtes Alkyl, Alkoxy, Alkenyl, Cycloalkyl, Cycloalkenyl, Aryl, Aralkyl, CN, Halogen, Amino oder Aminoalkyl oder quaternisiertem Amino oder quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten

$$-Q-Y-Q- \qquad \text{(III)}$$

in dem Q für einen carbocyclischen oder heterocyclischen, 5- oder 6-gliedrigen aromatischen Ring steht, wobei die beiden Bindungen zum Titanatom jeweils in Orthostellung zur Y-Gruppe stehen und die andere Orthostellung zu diesen Bindungen

jeweils durch ein Fluoratom substituiert ist, wobei die carbocyclischen und heterocyclischen Ringe $R^2$ bzw. Q gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ bedeutet,

$R^3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CN, $SiR^4_3$ oder $SnR^4_3$ ist oder die Bedeutung von $R^2$ hat, wobei für beide $R^1$ gleich unsubstituiertes Cyclopentadienyl$^{\ominus}$ nur einer der Reste $R^2$ und $R^3$ Pentafluorphenyl ist; mit Ausnahme der Verbindungen Bis-(cyclopentadienyl)-2,2'-octafluorbiphenyl-titan und Bis(indenyl)-bis(pentafluorphenyl)-titan.

Bei den Gruppen $R^1$ handelt es sich bevorzugt um gleiche Reste, Substituenten für $R^1$ sind:

lineares oder verzweigtes Alkyl, Alkoxy und Alkenyl, jeweils bevorzugt mit 1 bis 18, besonders 1 bis 12 und insbesondere 1 bis 6 C-Atomen, wie Methyl, Äthyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen;

Cycloalkyl und Cycloalkenyl, bevorzugt mit 5 bis 8 Ringkohlenstoffatomen wie z.B. Cyclopentyl, Cyclohexyl, Cycloheptyl, Methylpentyl und Methylcyclohexyl;

Aryl, bevorzugt mit 6 bis 16 C-Atomen und Aralkyl, bevorzugt mit 7 bis 16 C-Atomen wie z.B. Phenyl, Naphthyl, Pyridinyl, Benzyl und Phenyläthyl;

Cyano, Halogen, besonders F, C1 und Br sowie Amino, besonders tertiäres Amino, das lineare oder verzweigte Alkylgruppen mit 1 bis 12, besonders 1 bis 6 C-Atomen und insbesondere Methyl und Äthyl, Phenyl und Benzyl enthalten kann. Die Aminogruppen können auch quaternisiert sein, besonders mit linearen oder verzweigten Alkylhalogeniden mit vorzugsweise 1 bis 12 C-Atomen, besonders Methyl- oder Äthylhalogeniden;

lineares oder verzweigtes Aminoalkyl, besonders tertiäres Aminoalkyl, das auch quaternisiert sein kann, besonders mit Alkylhalogeniden. Die Alkylengruppe im Aminoalkyl kann linear oder verzweigt sein und enthält bevorzugt 1 bis 12, insbesondere 1 bis 6, C-Atome und ist ganz besonders Methylen, das mit $C_1$–$C_{12}$-Alkyl substituiert sein kann.

Die Reste $R^1$ können bis zu 3, besonders aber 1, Substituenten enthalten. Insbesondere sind beide $R^1$ Cyclopentadienyl$^{\ominus}$ oder Methylcyclopentadienyl$^{\ominus}$.

X in Formel II enthält in seiner Bedeutung als Alkyliden bevorzugt 2 bis 6 C-Atome. Beispiele für Alkyliden und Cycloalkyliden sind Äthyliden, Propyliden, Butyliden, Hexyliden, Cyclopentyliden und Cyclohexyliden. $R^4$ in der Gruppe X in seiner Bedeutung als Alkyl enthält bevorzugt 1 bis 6 C-Atome, z.B. Methyl, Äthyl, Propyl, Butyl oder Hexyl, und ist in seiner Bedeutung als Cycloalkyl bevorzugt Cyclopentyl der Cyclohexyl, in seiner Bedeutung als Aryl bevorzugt Phenyl und in seiner Bedeutung als Aralkyl bevorzugt Benzyl. Besonders bevorzugtes X ist Methylen.

Bei $R^2$ in seiner Bedeutung als 6-gliedriger carbocyclischer aromatischer und Fluor-substituierter Ring kann es sich beispielsweise um Inden, Indan, Fluoren, Naphthalin und besonders Phenyl handeln. Bevorzugt sind beide Orthostellungen mit Fluor substituiert. Beispiele sind: 4,6-Difluorinden-5-yl, 5,7-Difluorind-6-yl, 2,4-Difluorfluoren-3-yl, 1,3-Difluornaphth-2-yl und besonders 2,6-Difluorphen-1-yl.

$R^2$ als heterocyclischer aromatischer und 5-gliedriger Ring enthält bevorzugt ein Heteroatom und als 6-gliedriger Ring bevorzugt 1 oder 2 Heteroatome. Beispiele für solche mit 2 Fluoratomen substituierte Ringe sind: 2,4-Difluorpyrr-3-yl, 2,4-Difluorfur-3-yl, 2,4-Difluorthiophen-3-yl, 2,4-Difluorpyrid-3-yl, 3,5-Difluorpyrid-4-yl, 4,6-Difluorpyrimid-5-yl.

$R^2$ und $R^3$ zusammen als Rest der Formel III können z.B. sein:

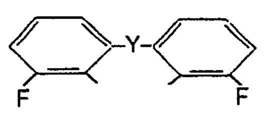 , 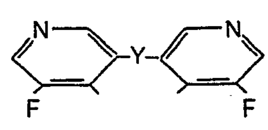 ,

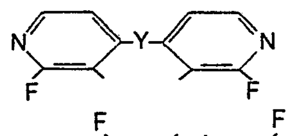 , 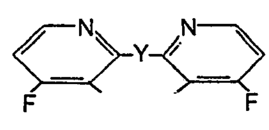 ,

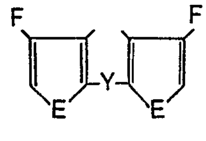 und 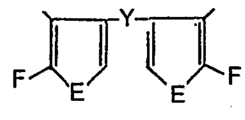

E bedeutet in den Formeln O, S oder NH. Y in Formel III und obigen Formeln ist bevorzugt Methylen, Äthyliden, Propyliden, eine direkte Bindung, S oder O.

Die Reste $R^2$ können teilweise oder vollständig durch weitere Gruppen substituiert sein, und zwar durch:

Lineares oder verzweigtes Alkyl oder Alkoxy, jeweils bevorzugt mit 1 bis 18, insbesondere 1 bis 6 C-Atomen, z.B. Methyl, Äthyl, Propyl, Butyl, Pentyl, Hexyl und die entsprechenden Alkoxygruppen, besonders Methyl und Methoxy;

Cycloalkyl, bevorzugt mit 5 oder 6 Ringkohlenstoffatomen, Aryl, bevorzugt mit 6 bis 16 C-Atomen und Aralkyl, bevorzugt mit 7 bis 16 C-Atomen wie z.B. Cyclopentyl, Cyclohexyl, Phenyl oder Benzyl; Hydroxyl, Carboxyl, CN, Halogen wie F, Cl oder Br und Amino, besonders tertiäres Amino, das mit Alkylhalogeniden wie Methylchlorid, -bromid oder -jodid quaternisiert sein kann. Beispiele für Amino sind Methylamino, Äthylamino, Dimethylamino, Diäthylamino, Pyrrolidyl, Piperidyl, Piperazyl, Morpholyl, N-Methylpiperazyl;

Alkoxycarbonyl, bevorzugt mit 1 bis 18, besonders 1 bis 6 C-Atomen in der Alkoxygruppe. Aminocarbonyl, bevorzugt mit ein oder zwei Alkylgruppen mit 1 bis 12 C-Atomen in der Amingruppe oder Amincarbonyl mit heterocyclischen Aminen wie Pyrrolidin, Piperidin, Piperazin, N-Methylpiperazin und Morpholin;

Aminoalkyl, besonders tertiäres Aminoalkyl mit bevorzugt $C_1$–$C_6$-Alkylgruppen, das mit Alkylhalogeniden quaternisiert sein kann. Bevorzugt ist Tertiäraminomethyl, das durch Alkyl mit 1 bis 12 C-Atomen substituiert sein kann. Beispiele sind Dimethylaminomethyl und Trimethylammoniummethyljodid.

Substituenten für $R^3$ als Phenylalkinyl sind Halogen wie F, Cl, Br, tertiär-Amino, Alkyl und Alkoxy mit 1 bis 6 C-Atomen, Carboxyl, OH und CN. $R^3$ hat bevorzugt die Bedeutung von $R^2$.

In einer bevorzugten Ausführungsform ist in Formel I′ $R^2$ 2,6-Difluorphen-1-yl oder $R^2$ und $R^3$ zusammen ein Rest der Formel

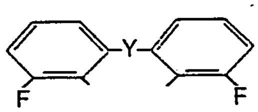 ,

worin Y die zuvor angegebene Bedeutung hat, wobei diese Reste gegebenenfalls weitere Substituenten tragen können, wie sie in Formel I′ als Substituenten für $R^2$ bzw. Q angeführt sind. Insbesondere sind $R^2$ und $R^3$ 2,6-Difluorphen-1-yl, das 1 bis 3 weitere derartige Substituenten enthält.

Eine bevorzugte Gruppe von Metallocenen der Formel I′ sind solche, worin beide $R^1$ Cyclopentadienyl$^{\ominus}$ oder durch $C_1$–$C_4$-Alkyl substituiertes Cyclopentadienyl$^{\ominus}$ und $R^2$ und $R^3$ ein Rest der Formel

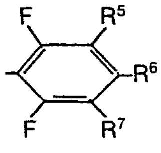

sind, worin $R^5$, $R^6$ und $R^7$ unabhängig voneinander für ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe stehen, wobei nur zwei der Reste $R^5$, $R^6$ und $R^7$ für Fluor stehen können. Die Aminoalkyl- und Ammoniumalkylgruppen sind bevorzugt in Parastellung zur freien Bindung gebunden. Eine bevorzugte Untergruppe sind solche, in denen $R^6$ für Fluor, $R^5$ für H, F, Cl oder Br und $R^7$ für H, Cl oder Br stehen, oder in denen $R^5$ und $R^7$ für H, Fluor, Chlor oder Brom und $R^6$ für H, Cl, Br, eine tertiäre Amino- oder Aminomethylgruppe oder eine quaternäre Ammonium- oder Ammoniummethylgruppe stehen.

Die Herstellung der Metallocene der Formel I′ erfolgt nach bekannten oder analogen Verfahren, indem man 1 Mol einer Verbindung der Formel IV,

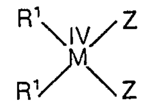 (IV)

worin $R^1$ und $M^{IV}$ die unter Formel I′ angegebene Bedeutung haben und Z für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ und $R^4$ die unter Formel I′ angegebene Bedeutung haben und $R^3$ Alkinyl, unsubstituiertes oder durch Halogen, tertiär-Amino, $C^1$–$C_6$-Alkyl oder -Alkoxy, Carboxyl, Hydroxy oder Cyano substituiertes Phenylalkinyl, $N_3$, CN, $SiR^4_3$ oder $SnR^4_3$ bedeutet und danach die Verbindungen der Formel I in an sich bekannter Weise isoliert.

Die bekannten Verfahren sind z.B. in J. Organometal. Chem., 2 (1964) 206–212 und J. Organometal. Chem., 4 (1965) 446–445 beschrieben.

Die Ausgangsverbindungen der Formel IV, in denen Z besonders für Chlor steht, sind bekannt. Die Lithiumverbindungen $LiR^2$ und $LiR^3$ sind ebenfalls bekannt oder können nach analogen Verfahren durch die Umsetzung von $R^2$- bzw. $R^3$-Halogeniden, besonders den Bromiden, mit Butyllithium hergestellt werden. Mit Tertiäraminomethylgruppen substituierte Derivate erhält man z.B. durch die Umsetzung von entsprechenden Difluordibromphenylverbindungen, die zunächst in Lithiumdifluorbromphenylverbindungen überführt, danach mit N,N-Dialkylmethylenammoniumchlorid umsetzt, worauf das entstandene Dialkylaminomethyl-difluorbromphenyl mit Butyllithium zur entsprechenden Lithiumverbindung umgesetzt wird.

Die Herstellung der Metallocene der Formel I′ erfolgt im allgemeinen in Gegenwart inerter Lösungsmittel wie z.B. Kohlenwasserstoffen oder Äthern bei Temperaturen unter −30 °C, z.B. −30 bis −100 °C, vorzugsweise −60 bis −90 °C und unter Schutzgasatmosphäre. In einer Ausführungsform des Verfahrens wird zunächst $LiR^2$ bzw. $LiR^3$ durch Umsetzung der entsprechenden Halogenide in Äther als Lösungsmittel mit Lithiumbutyl bei Temperaturen um −78 °C hergestellt. Zu der gekühlten Reaktionsmischung gibt man dann das entsprechende Metallocendihalogenid, entfernt die Kühlung und lässt auf Raumtemperatur erwärmen. Die Reaktionsmischung wird dann, gegebenenfalls nach Zugabe von Lösungsmitteln, filtriert und aus der Lösung durch Ausfällen oder

Verdampfen des Lösungsmittels das erfindungsgemässe Metallocen isoliert.

Es handelt sich im allgemeinen um feste, kristalline meist orangegefärbte Verbindungen, die sich durch eine hohe thermische Stabilität auszeichnen und sich erst um ihren Schmelzbereich zersetzen. Auch unter Lufteinwirkung sowie unter Einwirkung von Wasser wird keine Zersetzung beobachtet.

Die Verbindungen sind lagerstabil und können ohne Schutzgas gehandhabt werden. Sie eignen sich alleine hervorragend als sehr wirksame Photoinitiatoren für die lichtinduzierte Polymerisation äthylenisch ungesättigter Verbindungen. Sie zeichnen sich hierbei durch eine sehr hohe Lichtempfindlichkeit und Wirksamkeit über einen grossen Wellenlängenbereich von c. 200 nm (UV-Licht) bis etwa 600 nm aus. Ferner vermögen die Titanocene auch wirksam die Polymerisation unter dem Einfluss von Wärme zu initiieren, wobei ein Erwärmen auf 170 °C bis 240 °C zweckmässig ist. Selbstverständlich kann auch Lichteinwirkung und Erwärmung zur Polymerisation benutzt werden, wobei eine Erwärmung nach der Belichtung tiefere Temperaturen, z. B. 80–150 °C, zur Polymerisation erlaubt.

Ein weiterer Gegenstand vorliegender Erfindung ist eine durch Strahlung polymerisierbare Zusammensetzung, enthaltend neben üblichen Zusätzen (a) mindestens eine nichtflüchtige monomere, oligomere oder polymere Verbindung mit mindestens einer polymerisierbaren äthylenisch ungesättigten Doppelbindung und (b) mindestens ein Titanocen der Formel I

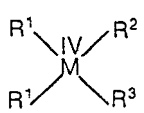 (I)

worin

M für ein vierwertiges Titanatom steht,

beide $R^1$ unabhängig voneinander Cyclopentadienyl$^{\ominus}$, Indenyl$^{\ominus}$ oder

beide $R^1$ zusammen für einen Rest der Formel II

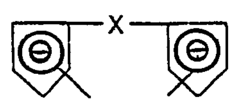 (II)

stehen, worin X $(CH_2)_n$ mit n = 1,2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_6$–$C_{12}$-Cycloalkyl, $C_6$–$C_{16}$-Aryl oder $C_7$–$C_{16}$-Aralkyl bedeutet, wobei die Reste Cyclopentadienyl$^{\ominus}$, Indenyl$^{\ominus}$ oder der Formel II jeweils unsubstituiert oder durch lineares oder verzweigtes Alkyl, Alkoxy, Alkenyl, Cycloalkyl, Cycloalkenyl, Aryl, Aralkyl, CN, Halogen, Amino oder Aminoalkyl oder quaternisiertem Amino oder quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten

$$-Q-Y-Q- \qquad (III),$$

in dem Q für einen carbocyclischen oder heterocyclischen 5- oder 6-gliedrigen aromatischen Ring steht, wobei die beiden Bindungen zum Titanatom jeweils in Orthostellung zur Y-Gruppe stehen und die andere Orthostellung zu diesen Bindungen jeweils durch ein Fluoratom substituiert ist, wobei die carbocyclischen und heterocyclischen Ringe $R^2$ bzw. Y gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet,

$R_3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CN, $SiR^4_3$ oder $SnR^4_3$ ist oder die Bedeutung von $R^2$ hat.

In der Zusammensetzung können die Metallocene die zuvor unter Formel I′ erwähnten Bevorzugungen haben, wobei jedoch für beide $R^1$ als unsubstituiertes π-Cyclopentadienyl $R^2$ und $R^3$ auch Pentafluorphenyl bedeuten können. Eine bevorzugte Zusammensetzung ist jene, in der in Formel I $R^1$ unsubstituiertes oder durch $C_1$–$C_4$-Alkyl substituiertes Cyclopentadienyl$^{\ominus}$ und $R^2$ und $R^3$ ein Rest der Formel

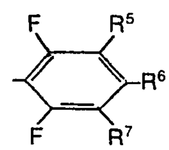

sind, worin $R^5$, $R^6$ und $R^7$ unabhängig voneinander ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe bedeuten. Die Aminoalkyl- bzw. Ammonium(alkyl)-gruppen sind vorzugsweise nur einmal vorhanden, und zwar in p-Stellung als $R^6$. Als besonders geeignet haben sich schon wegen der leichten Zugänglichkeit jene Metallocene erwiesen, in denen $R^5$, $R^6$ und $R^7$ Fluor bedeuten.

Die Zusatzmenge der erfindungsgemässen Metallocene richtet sich im wesentlichen nach wirtschaftlichen Gesichtspunkten, deren Löslichkeiten und nach der gewünschten Empflindlichkeit. Im allgemeinen werden 0,01 bis 25, vorzugsweise 0,1–20 und besonders 1 bis 10 Gew.% verwendet, bezogen auf die Komponente (a) und einen gegebenenfalls vorhandenen Binder (c).

Als Komponente (a) kommen solche äthylenisch ungesättigten monomeren, oligomeren und polymeren Verbindungen in Frage, die durch Photopolymerisation zu höhermolekularen Produkten reagieren und hierbei ihre Löslichkeit verändern.

Besonders geeignet sind z. B. Ester und Amide äthylenisch ungesättigter Carbonsäuren und Polyolen oder Polyepoxiden, und Polymere mit äthylenisch ungesättigten Gruppen in der Kette oder in Seitengruppen wie z. B. ungesättigter Polyester, Polyamide und Polyurethane und Copolymere hiervon, Polybutadien und Polybutadien-Copolymere, Polyisopren und Polyisopren-Copolymere, Polymere und Copolymere mit (Meth)Acrylgruppen in Seitenketten, sowie Mischungen von ein oder mehr solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Ölsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenylen, Bisphenole wie Bisphenol-A, sowie Novolake und Resole. Beispiele für Polyepoxide sind solche auf der Basis der genannten Polyole, besonders der aromatischen Polyole und Epichlorhydrin. Ferner sind auch Polymere oder Copolymere mit Hydroxylgruppen in der Polymerkette oder in Seitengruppen enthalten, wie z. B. Polyvinylalkohol und Copolymere oder Polymethacrylsäurehydroxyalkylester oder Copolymere, als Alkoholate geeignet. Weitere geeignete Diole sind Oligoester mit Hydroxylendgruppen.

Eine bevorzugte Gruppe von Polyolen sind solche der Formel $R^8(OH)_n$, worin $R^8$ ein n-wertiger, vorzugsweise 2- bis 8-, besonders 2- bis 6-wertiger aliphatischer Rest mit 2 bis 30 C-Atomen, der durch Stickstoff-, Schwefel- und besonders Sauerstoffatome sowie Cycloalkylen unterbrochen sein kann, oder Cycloalkylen mit 5 oder 6 Ringkohlenstoffatomen ist.

Beispiele für Polyole sind Alkylendiole mit bevorzugt 2 bis 12 C-Atomen, wie Äthylenglykol, 1,2- oder 1,3-Propandiol, 1,2-, 1,3- oder 1,4-Butandiol, Pentandiol, Hexandiol, Octandiol, Dodecandiol, Diäthylenglykol, Triäthylenglykol, Polyäthylenglykole mit Molekulargewichten von bevorzugt 100 bis 1500, 1,3-Cyclopentandiol, 1,2-, 1,3- oder 1,4-Cyclohexandiol, 1,4-Dihydroxymethylcyclohexan, Glycerin- Tris-(β-hydroxyäthyl)amin, Trimethyloläthan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z. B. veräthert oder mit anderen Carbonsäuren verestert sein können.

Beispiele für Ester sind:
Trimethylolpropantriacrylat, Trimethyloläthantriacrylat, Trimethylolpropantrimethacrylat, Trimethyloläthantrimethacrylat, Tetramethylenglykoldimethacrylat, Triäthylenglykoldimethacrylat, Tetraäthylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Äthylenglykoldimethacrylat, 1,3-Butandioldiacrylat, 1,3-Butandioldimethacrylat, 1,4-Butandioldiitaconat, Sorbittriacrylat, Sorbittetraacrylat, Sorbittetramethacrylat, Sorbitpentaacrylat, Sorbithexaacrylat, Pentaerythritmodifiziert-triacrylat, einem Oligoesteracrylat, einem Oligoestermethacrylat, Glyzerindi- und -triacrylat, 1,4-Cyclohexandiacrylat, Bisacrylate und Bismethacrylate von Polyäthylenglykol mit Molekulargewicht von 100–1500, oder Gemischen davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Amingruppen, und 2 bis 30, besonders 2 bis 18 C-Atomen, geeignet. Beispiele für Amine sind Alkylendiamine mit bevorzugt 2 bis 22 C-Atomen wie Äthylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoäthyläther, Diäthylentriamin, Triäthylentetramin, Di-(β-aminoäthoxy)- oder Di(β-aminopropoxy)äthan. Weitere geeignete Polyamine sind Polymere und Copolymere mit Aminogruppen in der Seitenkette und Oligoamide mit Aminoendgruppen. Beispiele sind: Methylenebis-acrylamid, 1,6-Hexamethylen-bis-acrylamid, Diäthylentriamin-tris-methacrylamid, Bis(methacrylamidopropoxy)-äthan, β-Methacryl-amidoäthylmethacrylat, N[(β-hydroxyäthyloxy)äthyl]-acrylamid.

Geeignete ungesättigte Polyester und Polyamide leiten sich z. B. von Maleinsäure und Diolen oder Diaminen ab. Die Maleinsäure kann teilweise durch andere Dicarbonsäuren ersetzt sein. Sie können zusammen mit äthylenisch ungesättigten Comonomeren, z. B. Styrol, eingesetzt werden. Die Polyester und Polyamide können sich auch von Dicarbonsäuren und äthylenisch ungesättigten Diolen oder Diaminen ableiten, besonders längerkettigen mit z. B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z. B. Polyolefine wie Äthylen, Propen, Buten, Hexen, (Meth)Acrylate, Acrylnitril, Styrol oder Vinylchlorid. Polymere mit (Meth)Acrylatgruppen in der Seitenkette sind ebenfalls bekannt. Es kann sich z. B. um Umsetzungsprodukte von Epoxidharzen auf Novolakbasis mit (Meth)Acrylsäure handeln, um Homo- oder Copolymere des Polyvinylalkohols oder deren Hydroxyalkylderivanten, die mit (Meth)Acrylsäure verestert sind, oder um

Homo- und Copolymere von (Meth)Acrylaten, die mit Hydroxyalkyl(meth)acrylaten verestert sind.

Die photopolymerisierbaren Verbindungen können alleine oder in beliebigen Mischungen eingesetzt werden. Vorteilhaft ist das Zumischen von Estern ungesättigter Carbonsäuren, besonders der (Meth)Acrylate von Polyolen. In einer anderen Ausführungsform werden (Meth)Acrylate von Polyolen alleine oder in Gemischen verwendet.

Den erfindungsgemässen Zusammensetzungen können auch Binder (c) zugesetzt werden, was besonders zweckmässig ist, wenn es sich bei den photopolymerisierbaren Verbindungen um flüssige oder viskose Substanzen handelt. Die Menge des Binders (c) kann z.B. 5–95, vorzugsweise 10–90 und besonders 50–90 Gew.% betragen, bezogen auf die vorhandene Menge an Komponente (b) und Binder (c).

Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000–2 000 000, bevorzugt 10 000 bis 1 00 000. Beispiele sind: Homo- und copolymere Acrylate und Methacrylate, z.B. Copolymere aus Methylmethacrylat/Äthylacrylat/Methacrylsäure, Poly(methacrylsäurealkylester), Poly(acrylsäurealkylester), wobei Akyl = $C_1$–$C_{20}$ ist, Celluloseester und -äther wie Celluloseacetat, Celluloseacetatbutyrat, Methylcellulose, Äthylcellulose, Polyvinylbutyral, Polyvinylformal, cyclisierter Kautschuk, Polyäther wie Polyäthylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylonitril, Methylmethacrylat und Vinylacetat, Polyvinylacetat, Copoly(äthylen/vinylacetat), Polyamide und Polycaprolactame wie Polycaprolactam und Poly(hexamethylenadipamid), Polyester wie Poly(äthylenglykolterephthalat) und Poly(hexamethylenglykolsuccinat).

Die erfindungsgemässe Zusammensetzung kann weitere übliche Zusatzstoffe enthalten, wie z.B. Inhibitoren der thermischen Polymerisation, Pigmente, Farbstoffe, Füllstoffe, Haftvermittler, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Papier, Keramik, Kunststoffen wie Polyester und Celluloseacetatfilmen und Metallen wie Kupfer und Aluminium, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen auf den Substraten.

Die Herstellung der beschichteten Substrate kann z.B. erfolgen, indem man eine Lösung oder Suspension der Zusammensetzung herstellt.

Die Wahl des Lösungsmittels und die Konzentration richtet sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B. durch Tauchen, Rakelbeschichtung, Vorhanggiessverfahren, Aufpinseln, Sprayen und Reverse roll Beschichtung. Die Auftragsmenge (Schichtdicke) und Art des Substrates (Schichtträger) sind abhängig vom gewünschten Applikationsgebiet. Für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen ca. 0,5 bis ca. 10 µm; für gedruckte Schaltungen 1 bis ca. 100 µm.

Die Photopolymerisation von (Meth)Acrylaten wird bekanntlich durch Luftsauerstoff gehemmt, besonders in dünnen Schichten. Dieser Effekt lässt sich mit bekannten üblichen Methoden wie z.B. Aufbringen einer Deckschicht aus Polyvinylalkohol oder eines Vorbelichten oder Vorkonditionieren unter Inertgas vermindern.

Nach dem Beschichten wird das Lösungsmittel durch Trocknen entfernt und es resultiert eine Schicht des lichtempfindlichen Polymers auf dem Träger. Nach der in üblicher Weise erfolgten bildmässigen Belichtung des Materials durch eine Photomaske werden die unbelichteten Stellen des Polymers durch Herauslösen in einem Entwickler entfernt und das Polymerrelief, bestehend aus vernetztem erfindungsgemässem Polymer freigelegt. Die Art des Entwicklers kann wässriger oder organischer Natur sein, je nach Art und Zusammensetzung der photopolymerisierbaren Schicht. Für carboxyxlgruppenhaltige Verbindungen und Binder sind z.B. wässrige Karbonatlösungen geeignet. Geeignete organische Entwickler sind z.B. chlorierte Kohlenwasserstoffe wie 1,1,1-Trichloräthan, Ketone wie Cyclohexanon, Ester wie Butylacetat und Acetoxymethoxyäthan, Alkohole wie Äthylcellosolve, Methylcellosolve und Butanol.

Die Lichtempfindlichkeit der erfindungsgemässen Materialien reicht vom UV-Gebiet (200 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Der Abstand zwischen Lampe und erfindungsgemässem Bildmaterial kann je nach Anwendungszweck und Lampentyp bzw. -stärke variieren, z.B. zwischen

2 cm bis 150 cm. Speziell geeignet sind Laserlichtquellen, z. B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Die wichtigsten Anwendungen sind die Verwendung als Ätzresist, Galvanoresist und Lötstopplack bei der Herstellung von gedruckten Schaltungen und Druckplatten, die Herstellung von Photopolymerdruckplatten für den Offsetdruck, Buchdruck (Hochdruck), sowie beim Flexodruck und Siebdruck als Abdecklack und zur Herstellung von photographischen Bildaufzeichnungsmaterialien, z. B. gemäss DE-A-26 51 864 oder DE-A-22 02 360.

Die nachfolgenden Beispiele erläutern die Erfindung näher.

A) Herstellung von Ausgangsprodukten
Synthese von Dimethylaminomethyl-p-bromtetrafluorbenzol

10 g (32,5 mMol) 1,4-Dibromtetrafluorbenzol werden in je 100 ml Äther und Tetrahydrofuran unter Argon als Schutzgas gelöst, auf −78° gekühlt und mit 21 ml Lithiumbutyl-Hexanlösung (1,6 molar) versetzt. Nach 15 Minuten werden 6,08 g (65 mMol) N,N-Dimethyl-methylenimmoniumchlorid zugegeben und die Mischung auf Raumtemperatur aufgewärmt. Nach 1 1/2 Stunden wird auf Wasser gegossen, mit Äther extrahiert und mit $MgSO_4$ getrocknet. nach dem Abdestillieren des Lösungsmittels erhält man einen weissen Festkörper, der am Hochvakuum bei 100° destilliert wird. Man erhält 7,8 g (84%) farbloses, bei Raumtemperatur festes Produkt.

B) Herstellungsbeispiele
Beispiele 1–28:

25 g Brompentafluorbenzol werden in 750 ml absolutem Äther gelöst und unter Argon-Schutzgas auf −78° gekühlt. Nach dem Versetzen mit 62,5 ml Lithiumbutyl-Hexan-Lösung (1,6 molar) wird während 15 Minuten bei −78° weitergerührt, 12,5 g $Cp_2TiCl_2$ als Pulver zugegeben und die Kühlung entfernt. Die Mischung wärmt sich innert 2 Stunden auf Raumtemperatur auf. Die orange Suspension wird eingedampft, in Methylenchlorid aufgeschlämmt und filtriert. Durch Zugabe von Hexan zur orangen Lösung wird das orange Produkt ausgefällt. Es resultieren nach dem Trocknen im Hochvakuum bei Raumtemperatur 23,6 g (92%) $Cp_2Ti(C_6F_5)_2$ in Form oranger Kristalle, die bei 230° unter Zersetzung schmelzen.

Analog werden die in folgender Tabelle angegebenen Verbindungen 2 bis 28 hergestellt. Cp bedeutet π-Cyclopentadienyl.

Tabelle

| Ausgangsmaterial/Reaktionsbedingungen | | | | |
|---|---|---|---|---|
| Bsp. | Ti-Verbindung | Lithiumbutyl in Hexan (1,6 m) | $C_6X_5$–Y | Lösungen Temperatur |
| 1 | $Cp_2TiCl_2$: 12,5 g | 62,5 ml | $C_6F_5Br$: 25 g | 750 ml abs. Äther/−78° |
| 2 | $Cp_2TiCl_2$: 1,245 g | 6,25 ml | 1,4-$Br_2C_6F_4$: 3,08 g | 120 ml abs. Äther/−78° |
| 3 | $Cp_2TiCl_2$: 2,5 g | 13 ml | 1,3-$Br_2C_6F_4$: 6,47 g | 100 ml abs. Äther/−78° |
| 4 | $Cp_2TiCl_2$: 2,5 g | 13 ml | 1-Br-2,3,4,6-$F_4C_6H$: 4,8g | 160 ml abs. Äther/−78° |
| 5 | $Cp_2TiCl_2$: 2,5 g | 13 ml | 1,3,5-$Cl_3CF_3$: 4,92 g | 160 ml abs. Äther/−78° |
| 6 | $Cp_2TiCl_2$: 2,5 g | 13 ml | 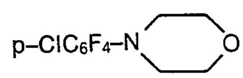 5,7 g | 80 ml THF, 80 ml Äther −78° |
| 7 | $Cp_2TiCl_2$: 2,5 g | 13 ml | 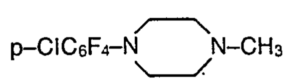 5,93 g | 80 ml THF, 100 ml Äther −78° |
| 8 | $(CH_3–Cp)_2TiCl_2$: 27,8g | 125 ml | $C_6F_5Br$: 50 g | 1,2 l abs. Äther/−78° |
| 9 | $(CH_3–Cp)_2TiCl_2$: 2,78 g | 13 ml | 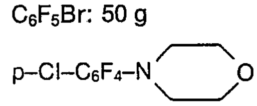 5,7 g | 80 ml THF, 100 ml Äther −78° |
| 10 | $(CH_3–Cp)_2TiCl_2$: 5,56 g | 27 ml | 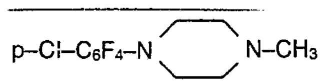 11,86 g | 80 ml THF, 100 ml Äther −78° |

Tabelle (Fortsetzung

| Ausgangsmaterial/Reaktionsbedingungen | | | | |
|---|---|---|---|---|
| Bsp. | Ti-Verbindung | Lithiumbutyl in Hexan (1,6 m) | $C_6X_5$–Y | Lösungen Temperatur |
| 11 | $Cp_2TiCl_2$: 3,375 g | 17 ml | 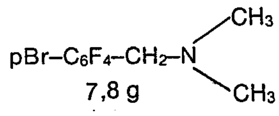 7,8 g | 200 ml Äther/ – 78° |
| 12 | $Cp_2TiCl_2$: 5 g | 27 ml | 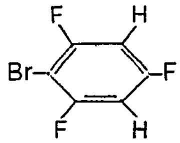 : 8,8 g | 150 ml Äther abs./ – 78° |
| 13 | $Cp_2TiCl_2$: 5 g | 27 ml | 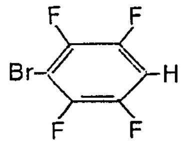 : 9,6 g | 150 ml Äther abs./ – 78° |
| 14 | $(CH_3–Cp)_2TiCl_2$: 5,56 g | 27 ml | 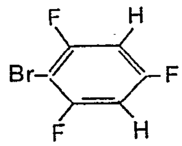 : 8,8 g | 150 ml Äther abs./ – 78° |
| 15 | $(CH_3–Cp)_2TiCl_2$: 5,56 g | 27 ml | 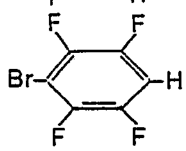 : 9,6 g | 150 ml Äther abs./ – 78° |
| 16 | $CpTiCl_2$: 5 g | 27 ml | 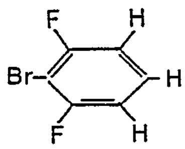 : 8,1 g | 150 ml Äther abs./ – 78° |
| 17 | $(CH_3–Cp)_2TiCl_2$: 5,56 g | 27 ml | 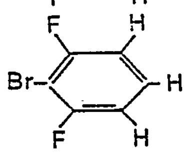 : 8,1 g | 150 ml Äther abs./ – 78° |
| 18 | $Cp_2TiCl_2$: 5 g | 27 ml | 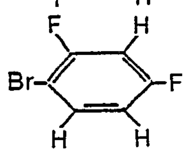 : 8,11 g | 150 ml Äther abs. / – 78° |
| 19 | $Cp_2TiCl_2$: 5 g | 27 ml | 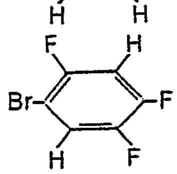 : 8,86 g | 150 ml Äther abs. / – 78° |
| 20 | $Cp_2TiCl_2$: 5 g | 27 ml | 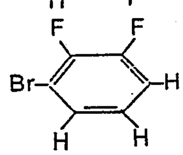 : 8,11 g | 150 ml Äther abs. / – 78° |
| 21 | $Cp_2TiCl_2$: 5 g | 27 ml | 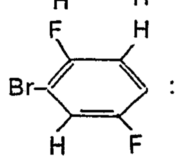 : 8,11 g | 150 ml Äther abs. / – 78° |
| 22 | $(CH_3Cp)_2TiCl_2$: 5,56 g | 27 ml | 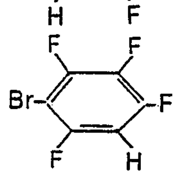 : 9,6 g | 150 ml Äther abs. / – 78° |

Tabelle (Fortsetzung

| Ausgangsmaterial/Reaktionsbedingungen | | | | |
|---|---|---|---|---|
| Bsp. | Ti-Verbindung | Lithiumbutyl in Hexan (1,6 m) | $C_6X_5$–Y | Lösungen Temperatur |
| 23 | $Cp_2TiCl_2$: 5 g | 27 ml | 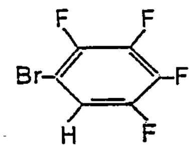 : 9,6 g | 150 ml Äther abs./−78° |
| 24 | $(CH_3Cp)_2TiCl_2$: 5,56 g | 27 ml | 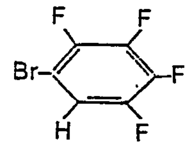 : 9,6 g | 150 ml Äther abs./−78° |
| 25 | $Cp_2TiCl_2$: 5 g | 27 ml | 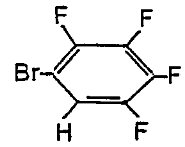 : 9,6 g | 150 ml Äther abs./–78° |
| 26 | $(CH_3–Cp)_2TiCl_2$: 5,56 g | 27 ml | 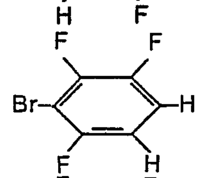 : 8,86 g | 150 ml Äther abs./−78° |
| 27 | 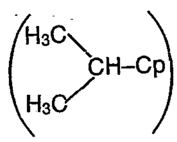 $_2TiCl_2$:6,12 g | 27 ml | 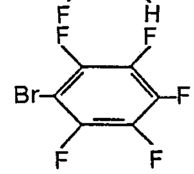 : 10,38 g | 150 ml Äther abs./−78° |
| 28 | $Cp_2TiCl_2$: 5 g | 27 ml | 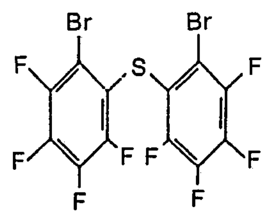 : 10,25 g | 150 ml Äther abs./−78° |

Tabelle

| Produkte und Eigenschaften | | | | | |
|---|---|---|---|---|---|
| Bsp. | Formel | Ausbeute % | Farbe | Zersp. | Eigenschaften |
| 1 | $Cp_2Ti(C_6F_5)_2$ | 92 | orange | 230° | luftstabil $H_2O$-stabil, lichtempfind-lich |
| 2 | $Cp_2Ti(p\text{-}Br–C_6F_4)_2$ | 73 | orange | 215° | luftstabil, lichtempfindlich |
| 3 | $Cp_2Ti(m\text{-}Br–C_6F_4)_2$ | 85 | orange | 253° | luftstabil, lichtempfindlich |
| 4 | $(p_2Ti(m\text{-}H–C_6F_4)_2$ | 90 | orange | 201° | luftstabil, lichtempfindlich |
| 5 | $Cp_2Ti(3,5\text{-}Cl_2C_6F_3)_2$ | 76 | orange | 249° | luftstabil, lichtempfindlich |
| 6 | $Cp_2Ti(p–C_6F_4$– 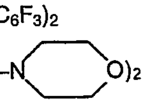 $)_2$ | 74 | rot | 228° | luftstabil, lichtempfindlich |
| 7 | $Cp_2Ti(p–C_6F_4$– 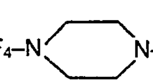 $–CH_3)_2$ | 80 | rot | 218° | luftstabil, lichtempfindlich |
| 8 | $(CH_3–Cp)_2Ti(C_6F_5)_2$ | 90 | orange | 192° | luftstabil, lichtempfindlich |

Tabelle (Fortsetzung)

Produkte und Eigenschaften

| Bsp. | Formel | Ausbeute % | Farbe | Zersp. | Eigenschaften |
|---|---|---|---|---|---|
| 9 | 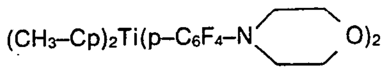 | 85 | rot | 212° | luftstabil, lichtempfindlich |
| 10 | 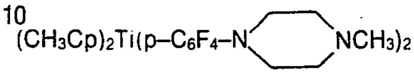 | 88 | rot | 190° | luftstabil, lichtempfindlich |
| 11 | 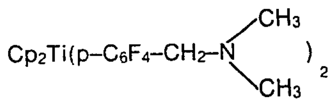 | 93 | orange | 203° | luftstabil, lichtempfindlich |
| 12 | 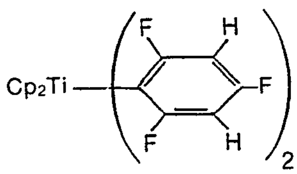 | 77 | orange | 208 | luftstabil, lichtempfindlich |
| 13 | 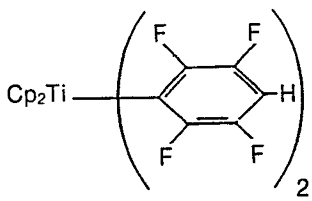 | 94 | orange | 218 | luftstabil, lichtempfindlich |
| 14 | 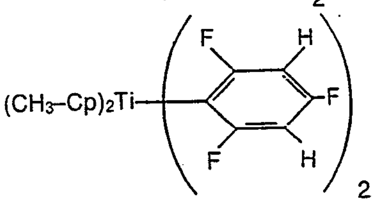 | 78 | orange | 165 | luftstabil, lichtempfindlich |
| 15 | 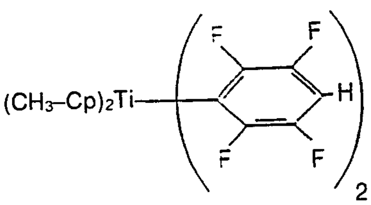 | 43 | orange | 192 | luftstabil, lichtempfindlich |
| 16 | 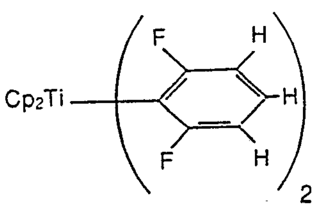 | 81 | orange | 205 | luftstabil, lichtempfindlich |
| 17 | 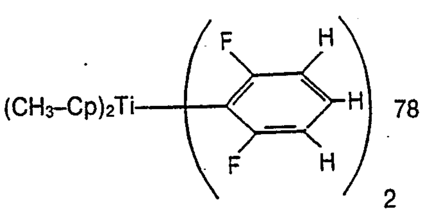 | 78 | orange | 190 | luftstabil, lichtempfindlich |
| 18 | 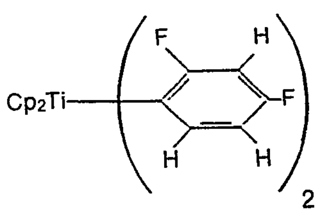 | 75 | gelb-orange | 167° | luftstabil, lichtempfindlich |

Tabelle (Fortsetzung)

Produkte und Eigenschaften

| Bsp. | Formel | Ausbeute % | Farbe | Zersp. | Eigenschaften |
|---|---|---|---|---|---|
| 19 | $Cp_2Ti$ 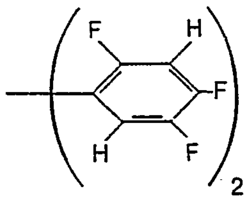 | 72 | gelb-orange | 160° | luftstabil, lichtempfindlich |
| 20 | $Cp_2Ti$ 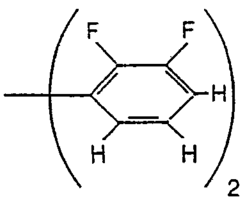 | 70 | gelb-orange | 160° | luftstabil, lichtempfindlich |
| 21 | $Cp_2Ti$ 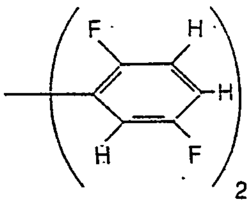 | 85 | gelb-orange | 170° | luftstabil, lichtempfindlich |
| 22 | $(CH_3-Cp)_2Ti$ 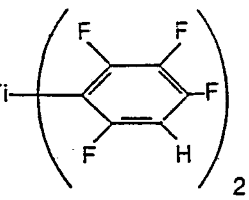 | 85 | orange | 167° | luftstabil, lichtempfindlich |
| 23 | $Cp_2Ti$ 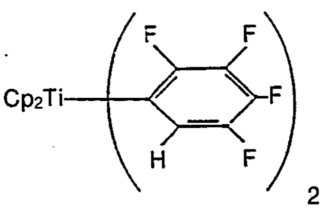 | 90 | orange | 195° | luftstabil, lichtempfindlich |
| 24 | $(CH_3-Cp)_2Ti$ 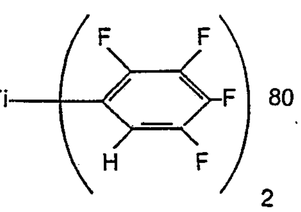 | 80 | orange | 150° | luftstabil, lichtempfindlich |
| 25 | $Cp_2Ti$ 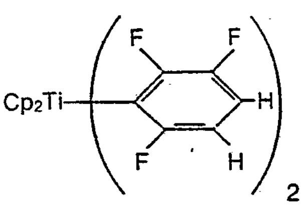 | 90 | orange | 217° | luftstabil, lichtempfindlich |
| 26 | $(CH_3-Cp)_2Ti$ 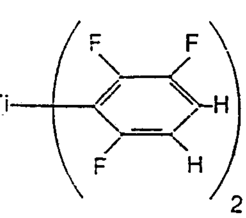 | 82 | orange | 150° | luftstabil, lichtempfindlich |

Tabelle (Fortsetzung)

Produkte und Eigenschaften

| Bsp. | Formel | Ausbeute % | Farbe | Zersp. | Eigenschaften |
|---|---|---|---|---|---|
| 27 | 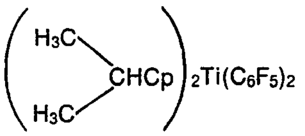 | 80 | orange | 229° | luftstabil, lichtempfindlich |
| 28 | 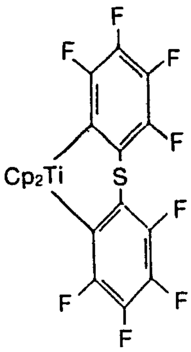 | 20 | orange | 229° | luftstabil, lichtempfindlich |

Beispiel 29: 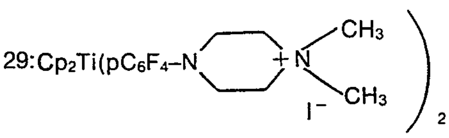

1,35 g 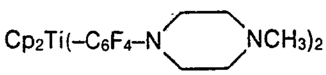

werden in 30 ml $CH_3CN$ gelöst, mit 0,5 ml Methyljodid versetzt und 1 Stunde bei Raumtemperatur gerührt. Die orange Lösung wird eingedampft und das Rohprodukt aus Methanol umkristallisiert. Es resultieren 1,72 g (90%) orange Kristalle, die bei 208° unter Zersetzung schmelzen.

Beispiel 30: 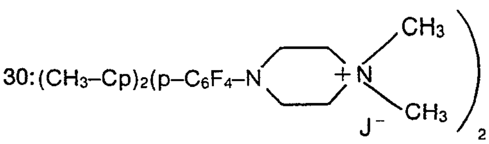

12 g 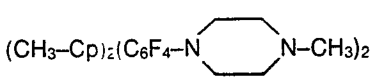

werden in 70 ml $CH_2Cl_2$ gelöst, mit 200 ml $CH_3CN$ verdünnt und mit 5 ml Methyljodid versetzt. Nach 1 Stunde wird die orange Lösung eingedampft und das Rohprodukt aus Methanol/Äther umkristallisiert. Es resultieren 15 g (90%) orange Kristalle, die bei 211° unter Zersetzung schmelzen.

Beispiel 31: 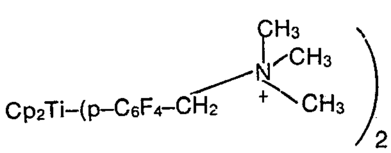

4,8 g $Cp_2Ti(-p-C_6F_4-CH_2N(CH_2)_2$ werden in 45 ml Methylenchlorid gelöst, mit 150 ml Acetonitril verdünnt und mit 2,03 ml Methyljodid versetzt. Nach 1 Stunde wird die orange Suspension filtriert. Es resultieren 5,2 g (73%) orange Kristalle, die bei 262° unter Zersetzung schmelzen. Aus der Mutterlauge können weitere 1,5 g (21%) Produkt isoliert werden.

C) Anwendungsbeispiele

Beispiele 32–49:

Alle Operationen werden unter Rotlicht ausgeführt. Eine Beschichtungslösung der folgenden Zusammensetzung wird hergestellt:

(MEK/MCS = Lösungsmittelgemisch Methyläthylketon/Methylcellosolve 1.1 v/v)

| | |
|---|---|
| Celluloseacetatbutyrat (10%ige Lösung in MEK/MCS) | 10,00 g |
| Pentaerythrittriacrylat (10%ige Lösung in MEK/MCS) | 10,00 g |
| Initiator | 0,100 g |
| Rote Pigmentpräparation (Mikrolithrot 241-GP60) | 0,100 g |
| Di-tert.butyl-p-kresol (DBPK) | 0,002 g |

Nach dem Mischen der Komponenten wird bis zur Lösung gerührt. Die Lösung beschichtet man mittels eines Drahtrakels mit 40 µm Nassfilmdicke auf eine vorbehandelte Aluminumträgerfolie (Offsetplatten-Substrat) und trocknet 3 Minuten bei 80 °C. Auf die trockene lichtempfindliche Schicht wird eine Polyvinylalkohol-Schutzschicht aus einer Lösung folgender Zusammensetzung aufgebracht:

| | |
|---|---|
| Polyvinylalkohol (Mowiol 4–88) | 10,00 g |
| Triton X-100 | 0,100 g |
| Deionisiertes Wasser | 90,00 g |

Man beschichtet mit 40 μm Nassfilmdicke und trocknet 5 Minuten bei 80°.

Das lichtempfindliche Material belichtet man in Kontakt mit einem Testnegativ, das einen Graukeil mit Dichteinkrementen von OD=0,15 (Stouffer-Keil) aufweist. Als Belichtungsgerät dient ein Kopierapparat (Océ Helioprint 36) mit einer 1000 W Metall-Halogenlampe im Abstand von 53 cm, wobei die Belichtungszeit mit einer Photozelle gesteuert wird (1 Impuls = ca. 1 Sekunde).

Nach der Belichtung entfernt man die Polyvinylalkohol-Schutzschicht durch Abspülen mit Wasser während 1 Minute. Durch Eintauchen in bewegte MEK/MCS 1:1-Lösung bei Raumtemperatur während 1 1/2 Minuten wird das gefärbte Reliefbild entwickelt, kurz mit frischer MEK/MCS-1:1-Lösung gespült und mit Luft getrocknet. Die Bestimmung der Empfindlichkeit geschieht durch Zählen der abgebildeten Keilstufen. Die Resultate sind in nachfolgender Tabelle dargestellt.

Tabelle

| Beispiel Nr. | Initiator Nr. | Zahl der abgebildeten Keilstufen bei Belichtungszeit (Zahl der Impulse) 1 I | 5 I | 10 I | 15 I |
|---|---|---|---|---|---|
| 32 | 1 | 7 | 12 | 14 | 15 |
| 33 | 8 | 6 | 11 | 13 | 14 |
| 34 | 2 | 7 | 12 | 14 | 15 |
| 35 | 5 | 6 | 11 | 12 | 13 |
| 36 | 4 | 7 | 12 | – | 16 |
| 37 | 6 | 6 | 11 | – | 15 |
| 38 | 7 | 1–2 | 5 | – | 10 |

Beispiele 39 und 40:

Sie zeigen den Einfluss der Initiatorkonzentration auf die Empfindlichkeit. Man verwendet die Beschichtungslösung von Beispiel 32 mit verschiedenen Mengen Initiator Nr. I und verfährt im übrigen gleich wie bei Beispiel 32.

| | |
|---|---|
| Beispiel 39: Verbindung Nr. 1 | 0,020 g |
| Beispiel 32: Verbindung Nr. 1 | 0,100 g |
| Beispiel 40: Verbindung Nr. 1 | 0,200 g |

Die Resultate sind in nachfolgender Tabelle angegeben.

Tabelle

| Beispiel Nr. | Initiator | Belichtungszeit (Zahl der Impulse) 1 I | 5 I | 10 I | 15 I |
|---|---|---|---|---|---|
| 39 | 1%** | 3* | 8 | 11 | 12 |
| 32 | 5% | 7 | 12 | 14 | 15 |
| 40 | 10% | 9 | 14 | 15 | 17 |

* Zahl der abgebildeten Keilstufen

** Prozentuale Menge bezogen auf Bindepolymer + oligomeres Acrylat.

Beispiel 41: Belichtung mit sichtbarem Licht.

Man verwendet das lichtempfindliche Material des Beispiels 32. Als Belichtungsgerät dient eine Xenon-Lampe mit «cut off» Filter CG 475 (Jena-Schott) im Abstand von 108 cm. Dieses Filter absorbiert alle unter 485 nm liegende Lichtstrahlung. Entwicklung und Auswertung erfolgt gemäss Beispiel 32. Die Resultate sind in nachfolgender Tabelle aufgeführt.

Tabelle

| Beispiel Nr. | Initiator Nr. | Belichtungszeit in Minuten 1 | 2 | 3 | 4 | 5 min |
|---|---|---|---|---|---|---|
| 41 | 1 (5%) | 1* | 3 | 4 | 5 | 6 |

* Zahl der abgebildeten Keilstufen

Beispiel 42: Belichtung mit sichtbarem Laserlicht (514 nm)

Man verwendet das lichtempfindliche Material gemäss Beispiel 21. Als Lichtquelle dient der Strahl eines Argonionenlasers mit einem Durchmesser von ca. 1 mm und der Linienfrequenz von 514 nm. Die Leistung lässt sich mit einem Absorptionsfilter variabel einstellen. Das lichtempfindliche Material wird auf einer rotierenden Kreisscheibe befestigt und mit bekannter Kreisgeschwindigkeit am fixen Laserstrahl vorbeigeführt. Derart mit einem Kreislinienmuster belichtete Muster werden gemäss Beispiel 32 entwickelt. Bei einer Laserleistung von 0,5 m Watt und einer Schreibgeschwindigkeit von 0,35 m/sec ist der Kreis sichtbar abgebildet.

Beispiel 43: Thermische Stabilität

Verwendet wird das lichtempfindliche Material gemäss Beispiel 32. Es wird in einem Ofen während 16 Stunden bei 80 °C in Luft erhitzt und dann wie in Beispiel 32 belichtet und entwickelt. Das Material ist auch nach dieser thermischen Behandlung noch gut entwickelbar.

Beispiel 44:

Die folgende Beschichtungslösung wird hergestellt:

| | |
|---|---|
| Copolymer aus Methylmethacrylat/Ethylacrylat/ Methacrylsäure 60:25:15 Gew.-% [10%ige Lösung in MEK/MCS] | 10,00 g |
| Pentaerythrittriacrylat [10%ige Lösung in MEK/MCS] | |
| Initiator Nr. 1 | 0,100 g |
| Rote Pigmentpräparation (Mikrolithrot 241-GB60) | 0,100 g |
| Di-tert.butyl-p-kresol | 0,002 g |

Die Lösung beschichtet man gemäss Beispiel 32 auf Aluminium und versetzt mit einer Polyvinylalkohol-Schutzschicht. Nach 15 Impulsen Belichtungszeit mit dem in Beispiel 32 genannten Kopierapparat wird durch Eintauchen in bewegte 1%-$Na_2CO_3$-Lösung bei Raumtemperatur während 60 Sekunden entwickelt, 15 Sekunden mit Wasser abgespült und getrocknet. Es sind 10 Keilstufen abgebildet.

Beispiel 45:

Folgende Beschichtungslösung wird hergestellt:

| | |
|---|---|
| Copolymer aus Methylmethacrylat/Äthylacrylat/ Methacrylsäure 60:25:15 Gew.% | 5,100 g |
| Triäthyleneglykoldimethylacrylat | 0,900 g |
| Initiator Nr. 1 | 0,300 g |
| Farbstoff (Orasol B) | 0,012 g |
| Di-tert.butyl-p-kresol | 0,030 g |
| Methylcellosolve | 14,00 g |

Die Lösung wird mittels eines Drahtrakels mit 100 µm Nassfilmdicke auf ein Kupfer-kaschiertes Laminat, das zur Herstellung von Leiterplatten verwendet wird, geschichtet und 25 Minuten bei 80 °C getrocknet. Die Photopolymerschichtdicke beträgt ca. 30 µm. Die Platte wird auf dem in Beispiel 32 beschriebenen Kopierapparat durch ein Testnegativ während 30 Impulsen belichtet und durch Eintauchen in bewegte 1%-$Na_2CO_3$-Lösung entwickelt.

Auf diese Platte können nun in bekannter Weise die Leiterzüge durch galvanische Kupferabscheidung verstärkt werden.

Beispiel 46:

1,0 g von Polybutadien ($\overline{M}_w$ = 0,67 · $10^6$, $\overline{M}_w/\overline{M}_n$ = 8,7, 97% cis-1,4-, 2%-trans-1,4-, 1% 1,2-vinyl-Strukturen) und 50 mg $(C_5H_5)_2Ti\ (C_6F_5)_2$ werden in 9,45 g Toluol gelöst und im roten Licht mit einer 50 µm-Rakel auf eine Kupfer-Leiterplatte geschichtet. Die Beschichtung wird 3 Minuten bei 80 °C getrocknet und durch einen Stufenkeil der Fa. Stouffer («21 Step Sensitivity Guide») mit einem 5000 W Hochdruckbrenner aus einer Distanz von 70 cm belichtet. Die unbelichteten Teile werden während 2 Minuten in Toluol ausgewaschen. Das Ergebnis ist in nachfolgender Tabelle dargestellt.

Tabelle

| Belichtungszeit (Minuten) | Zahl der abgebildeten Keilstufen |
|---|---|
| 2 | 1 |
| 3 | 3 |
| 4 | 5 |

Beispiel 47:

1,0 g eines ungesättigten Polyamids mit der wiederkehrenden Einheit

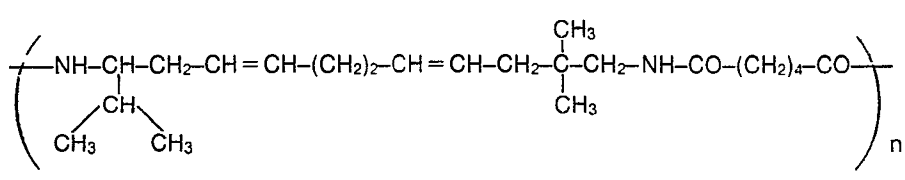

($\mu_{red}$ = 0,88 dl/g in einer 0,5%igen m-Kresol-Lösung bei 25 °C) und 50 mg $(C_5H_5)_2Ti(C_6F_5)_2$ werden in 9,45 g Chloroform gelöst und weiter verarbeitet wie im Beispiel 35.

Die Beschichtung wird während 10 Minuten belichtet und die unbelichteten Anteile in Chloroform ausgewaschen. Es erscheinen die Konturen der Kopie der photographischen Maske.

Beispiel 48:

5,0 g Setarol 3606 MV'' (eine 41%ige Styrol-Lösung eines Polyesters aus 100 Gew.Teilen Propylenglykol, 72 Gew.-Teilen Maleinsäureanhydrid und 54 Gew.-Teilen Phthalsäureanhydrid, Lösungs-Viskosität bi 20 °C 1000 mPa.s, Produkt der Firma Synthese B.V. und 100 mg $(C_5H_5)_2Ti(C_6F_5)_2$ werden zusammengemischt. Mit der Lösung wird eine Kupfer-Leiterplatte mit Hilfe einer 4 µm-Rakel beschichtet und durch einen photographischen Stufenkeil «21 Step Sensitivity Guide» der Firma Stouffer mit einer 2000 W Hochdrucklampe aus einer 70 cm-Distanz belichtet. Die unbelichteten Anteile werden mit Aceton ausgewaschen. Das Ergebnis ist in nachfolgender Tabelle dargestellt.

Tabelle

| Belichtungszeit (sec.) | Zahl der abgebildeten Keilstufen |
|---|---|
| 2 | 2 |
| 3 | 3 |
| 5 | 5 |

Beispiel 49:

0,5 g eines Polyesters aus Maleinsäureanhydrid und Cyclohexandimethanol (Tg = 40 °C, $\eta_{red}$ = 0,92 dl/g in einer 0,5%igen m-Kresol-Lösung) und 25 mg $Cp_2Ti(C_6F_5)_2$ werden in 9,5 g Chloroform gelöst und im roten Licht mit einer 50 µm-Rakel auf eine Kupfer-Leiterplatte aufgeschichtet. Die Beschichtung wird 3 Minuten bei 80 °C getrocknet und durch einen Stufenkeil der Fa. Stouffer («21 Step Sensitivity Guide») mit einem 5000 W Hochdruckbrenner MO 23- oder MO 33-Sylvania[R], aus einer Distanz von 70 cm belichtet. Die unbelichteten Teile werden während 30 Sekunden in Dimethylformamid ausgewaschen. Das Ergebnis ist in nachfolgender Tabelle dargestellt.

Tabelle

| Belichtungszeit (sec) | | Zahl der abgebildeten Keilstufen |
|---|---|---|
| MO 23 | MO 35 | |
| | 60 | 3 |
| | 120 | 5 |
| 60 | | 14 |

Beispiele 50–64:

Es wird folgende Beschichtungslösung hergestellt:

50 Gew.-Teile Copolymer gemäss Beispiel 44 (10%ige Lösung in MEK/MCS)
50 Gew.-Teile Pentaerythrittriacrylat (10%ige Lösung in MEK/MCS)
5 Gew.-Teile Titanocen-Initiator
0,1 Gew.-Teile Di-tert.-butyl-p-kresol

Die Lösung wird gemäss Beispiel 32 auf Aluminium beschichtet, getrocknet (Auftragegewicht ca. 2,5–3 g/m²) und mit einer Polyvinylalkohol-Schutzschicht (ca. 3 g/m²) versehen. Danach wird gemäss Beispiel 32 mit 10 Impulsen durch einen Stouffer-Keil belichtet und anschliessend während 60 Sekunden bei 20 °C mit einer 1%-igen wässrigen $Na_2CO_3$-Lösung entwickelt. Zur Sichtbarmachung des Bildes wird darauf mit einer 1-%igen wässrigen Lösung des Farbstoffes Rhodamine B® bei einem pH = 7 während 30 Sekunden bei 20 °C eingefärbt.

In der nachfolgenden Tabelle sind die verwendeten Initiatoren und Zahl der abgebildeten Stufen angegeben.

| Beispiel No. | Initiator | Zahl der abgebildeten Stufen |
|---|---|---|
| 50 | $Cp_2Ti(C_6F_5)_2$ | 14 |
| 51 | $(CH_3Cp)_2Ti(C_6F_5)_2$ | 11 |
| 52 | $(Cp)_2Ti(p\text{-}BrC_6F_4)_2$ | 10 |
| 53 | $(Cp)_2Ti(m\text{-}HC_6F_4)_2$ | 14 |
| 54 | 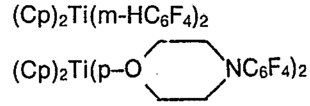 | 11 |
| 55 | 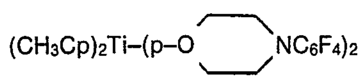 | 11 |
| 56 | $(Cp)_2Ti(3,5H_2C_6F_3)_2$ | 13 |
| 57 | $(CH_3Cp)_2Ti(3,5\text{-}H_2C_6F_3)_2$ | 12 |
| 58 | $(Cp)_2Ti(2,6\text{-}F_2C_6H_3)_2$ | 15 |
| 59 | $(CH_3Cp)_2Ti(2,6\text{-}F_2C_6H_3)_2$ | 13 |
| 60 | $(Cp)_2Ti(o\text{-}HC_6F_4)_2$ | 11 |
| 61 | $(CH_3Cp)_2Ti(o\text{-}HC_6F_4)_2$ | 12 |
| 62 | $(Cp)_2Ti(2,3,6\text{-}F_3C_6H_2)_2$ | 14 |
| 63 | $(CH_3Cp)_2Ti(2,3,6\text{-}F_3C_6H_2)_2$ | 11 |
| 64 | 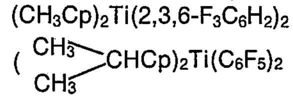 | 11 |

Beispiel 65: Empfindlichkeitsbestimmung bei 488 nm und 515 nm Lagerlicht.

Unter Rotlicht wird folgende Beschichtungslösung hergestellt:

| | |
|---|---|
| Copolymer aus Methylmethacrylat/Äthylmethacrylat/Methacrylsäure 65:25:15 Gew.-% (40%ige Lösung in MEK) | 2,50 g |
| Pentaerythrittriacrylat (40%ige Lösung in MEK) | 2,50 g |
| Initiator Nr. 1 (1 g Initiator in 100 ml Äthylglycolacetat) | 10,00 ml |
| Farbstoff Oralsolrosa 5 BLG® (1 g Farbstoff in 100 ml Äthylglykol) | 2,00 ml |
| Di-tert.-butyl-p-kresol (1 g in 100 ml Äthylglykolacetat) | 0,20 ml |
| Äthylglykolacetat | 2,00 ml |

Diese Lösung wird auf Aluminiumplatten aufgeschleudert und die beschichteten Platten 5 Minuten bei 80° getrocknet. Auftragsmenge = 1,15 g/m². Dann wird eine Polyvinylalkoholschutzschicht aufgebracht. Auftragsmenge ca. 3,0 g/m².

Danach wird mit einem aufgeweiteten Argon-Laserstrahl (I = 1 mW/cm², Coherent 90–5) durch eine Lochblende (Ø = 1 cm) belichtet. Die Belichtungszeiten betragen 0,2; 0,4; 0,6; 0,8; 1 und 2 sec.

Nach jeder Belichtung wird das Material etwas vorgeschoben, so dass eine Serie von belichteten Kreisflächen entsteht. Das belichtete Material wird wie folgt entwickelt:

| | |
|---|---|
| Abspülen mit Leitungswasser | 1 Min. |
| Entwickeln in 1%-$Na_2CO_3$-Lösung bei 20 °C | 1 Min. |
| Spülen mit Leitungswasser | 15 Sec. |

Die letzte noch sichtbare Kreisfläche gibt die minial benötigte Belichtungsenergie $E_{min.}$ an.

Resultat:

A) Laserlicht 488 nm: $E^{488}_{min.} = 0,4\text{–}0,6\ mJ/cm^2$

B) Laserlicht 514,5 nm: $E^{514}_{min.} = 0,8\text{–}1,0\ mJ/cm^2$.

Beispiel 66:

Es werden die folgenden Komponenten verwendet:

Polyamidsäure ($\overline{M}_w$ = 14 000) wiederkehrenden Strukturelementen der Formel

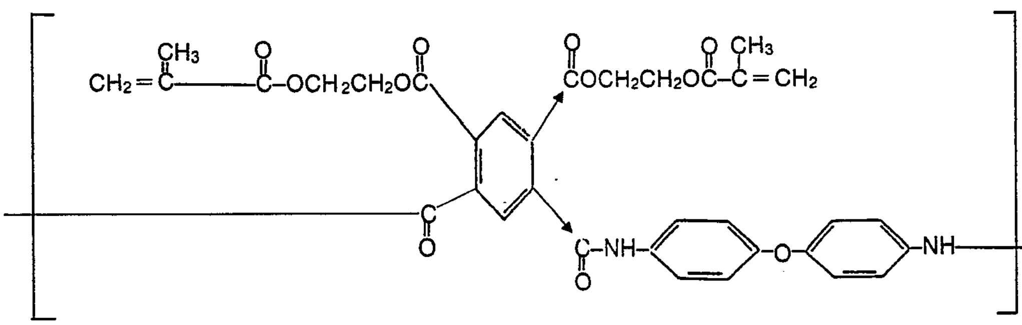

31 g

| | |
|---|---|
| N-Methylpyrolidon (NMP) | 69 g |
| $[(Cp)_2Ti(C_6F_5)_2]$ | 1,55 g |
| Tetraäthylenglykoldimethacrylat | 3,1 g |
| Orasolblau | 0,4 g |

Die Komponenten werden vereinigt und gelöst und mittels einer Rakel-Beschichtungsmaschine auf Aluminiumsubstrate aufgebracht (Schichtstärke der ungetrockneten Schicht ca. 12 µm). Nach 10 Minuten Trocknung im Umluftofen bei 70 °C erfolgt die Belichtung mittels einer Quecksilberhochdrucklampe. Die Entwicklung erfolgt für 22 sec. in einem Tauchbad von Toluol und 4-Butyrolacton im Verhältnis 1:1 bei einer Temperatur von 23 °C. Bei einer Lampenleistung von 37,5 mW/cm² und einer Substrattemperatur nache 23 °C wird eine Belichtungszeit von nur 1 sec. benötigt, um mittels eines Stouffer-Graukeils 2–3 Stufen zu erzeugen.

**Patentansprüche für die Vertragsstaaten BE, CH, DE, FR, GB, IT, LI, NL, SE**

1. Titanocene der Formel I'

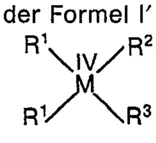

(I')

worin

M für ein vierwertiges Titanatom steht,

beide $R^1$ unabhängig voneinander Cyclopentadienyl$^\ominus$, Indenyl$^\ominus$ oder beide

$R^1$ zusammen für einen Rest der Formel II

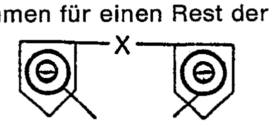

(II)

stehen, worin X $(CH_2)$ mit n = 1, 2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet, wobei die Reste Cyclopentadienyl$^\ominus$, Indenyl$^\ominus$ oder der Formel II jeweils unsubstituiert oder durch lineares oder verzweigtes Alkyl, Alkoxy, Alkenyl, Cycloalkyl, Cycloalkenyl, Aryl, Aralkyl, CN, Halogen, Amino oder Aminoalkyl oder quaternisiertem Amino der quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten

$$-Q-Y-Q- \qquad \text{(III)}$$

in dem Q für einen carbocyclischen oder heterocyclischen, 5- oder 6-gliedrigen aromatischen Ring steht, wobei die beiden Bindungen zum Titanatom jeweils in Orthostellung zur Y-Gruppe stehen und die andere Orthostellung zu diesen Bindungen jeweils durch ein Fluoratom substituiert ist, wobei die carbocyclischen und heterocyclischen Ringe $R^2$ bzw. Q gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet,

$R^3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CHn $SiR^4_3$ oder $SnR^4_3$ ist oder die Bedeutung von $R^2$ hat, wobei für beide $R^1$ gleich unsubstituier-

tes Cyclopentadienyl$^{\ominus}$ nur einer der Reste $R^2$ und $R^3$ Pentafluorphenyl ist; mit Ausnahme der Verbindungen Bis-(cyclopentadienyl)-2,2'-octafluorbiphenyl-titan und Bis(indenyl)-bis(pentafluorphenyl)-titan.

2. Titanocene gemäss Anspruch 1, worin $R^2$ 2,6-Difluorphen-1-yl oder $R^2$ und $R^3$ zusammen ein Rest der Formel

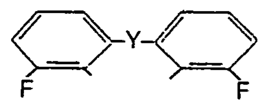

ist, worin Y die zuvor angegebene Bedeutung hat, wobei diese Reste gegebenenfalls weitere Substituenten tragen können, wie sie in Anspruch 1 als Substituenten für $R^2$ bzw. Q angeführt sind.

3. Titanocene gemäss Anspruch 1, worin $R^2$ und $R^3$ die gleiche Bedeutung haben.

4. Titanocene gemäss Anspruch 3, worin $R^2$ und $R^3$ 2,6-Difluorphen-1-yl sind, das 1 bis 3 weitere Substituenten, wie sie in Anspruch 1 als Substituenten für $R^2$ bzw. Q angeführt sind, enthält.

5. Titanocene gemäss Anspruch 1, worin $R^1$ Cyclopentadienyl$^{\ominus}$ oder durch $C_1$–$C_4$-Alkyl substituiertes Cyclopentadienyl$^{\ominus}$ und $R^2$ und $R^3$ ein Rest der Formel

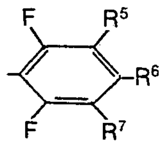

sind, worin $R^5$, $R^6$ und $R^7$ unabhängig voneinander für ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe stehen, wobei nur zwei der Reste $R^5$, $R^6$ und $R^7$ Fluor bedeuten können.

6. Titanocene gemäss Anspruch 5, worin $R^6$ für Fluor, $R^5$ für H, Fluor, Chlor oder Brom und $R^7$ für H, Cl oder Br, oder $R^5$ und $R^7$ für H, Fluor, Chlor oder Brom und $R^6$ für H, Chlor, Br, eine tertiär-Aminogruppe, eine tertiäre Aminoalkylgruppe oder eine quaternäre Ammonium- oder Ammoniumalkylgruppe stehen.

7. Verfahren zur Herstellung von Titanocenen der Formel I' gemäss Anspruch 1, dadurch gekennzeichnet, dass man 1 Mol einer Verbindung der Formel

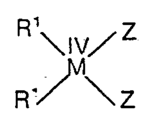

(IV)

worin $R^1$ und $M^{IV}$ die in Anspruch 1 angegebene Bedeutung haben und Z für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ und $R^4$ die in Anspruch 1 angegebene Bedeutung haben und $R^3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CN, $SiR^4_3$ oder $SnR^4_3$ bedeutet, und danach die Verbindungen der Formel I in an sich bekannter Weise isoliert.

8. Durch Strahlung polymerisierbare Zusammensetzung, enthaltend neben üblichen Zusätzen (a) mindestens eine nichtflüchtige, monomere, oligomere oder polymere Verbindung mit mindestens einer polymerisierbaren äthylenisch ungesättigten Doppelbindung und (b) mindestens ein Titanocen der Formel I als Photoinitiator

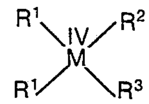

(I)

worin

M für ein vierwertiges Titanatom steht,

beide $R^1$ unabhängig voneinander Cyclopentadienyl$^{\ominus}$, Indenyl$^{\ominus}$ oder beide $R^1$ zusammen für einen Rest der Formel II

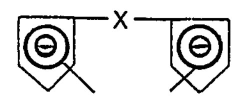

(II)

stehen, worin X $(CH_2)_n$ mit n = 1,2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet, wobei die Reste Cyclopentadienyl$^{\ominus}$, Indenyl$^{\ominus}$ oder der Formel II jeweils unsubstituiert oder durch lineares oder verzweigtes Alkyl, Alkoxy, Alkenyl, Cycloalkyl, Cycloalkenyl, Aryl, Aralkyl, CN, Halogen, Amino oder Aminoalkyl oder quaternisiertem Amino oder quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten

$$-Q-Y-Q- \qquad (III),$$

in dem Q für einen carbocyclischen oder heterocyclischen 5- oder 6-gliedrigen aromatischen Ring steht, wobei die beiden Bindungen zum Titanatom jeweils in Orthostellung zur Y-Gruppe stehen und die andere Orthostellung zu diesen Bindungen jeweils durch ein Fluoratom substituiert ist, wobei die carbocyclischen und heterocyclischen Ringe $R^2$ bzw. Q gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_3$ bedeutet,

$R_3$ Alkyinyl, unsubstituiertes oder durch Halogen, tertiär-Amino, $C_1$–$C_6$-Alkyl oder -Alkoxy, Carboxyl, Hydroxy oder Cyano substituiertes Phe-

nylalkinyl, $N_3$, CN, $SiR^4_3$ oder $SnR^4_3$ ist oder die Bedeutung von $R^2$ hat.

9. Zusammensetzung gemäss Anspruch 8, worin die Verbindung (a) ausgewählt ist aus der Gruppe der Ester und Amide ungesättigter Carbonsäuren, der ungesättigten Polyester, Polyamide und Polyurethane, Polybutadien und Polybutadien-Copolymeren, Polyisopren und Polyisopren-Copolymeren.

10. Zusammensetzung gemäss Anspruch 8, worin die Verbindung (a) ein Acryl- oder Methacrylsäureester eines organischen Polyols ist.

11. Zusammensetzung gemäss Anspruch 8, worin in Formel I $R^1$ unsubstituiertes oder durch $C_1$–$C_4$-Alkyl substituiertes Cyclopentadienyl$^{\ominus}$ und $R^2$ und $R^3$ ein Rest der Formel

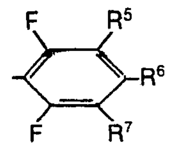

sind, worin $R^5$, $R^6$ und $R^7$ unabhängig voneinander ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe bedeuten.

12. Zusammensetzung gemäss Anspruch 1, worin $R^5$, $R^6$ und $R^7$ für F stehen.

13. Beschichtetes Substrat, enthaltend als photopolymersierbare Schicht eine Zusammensetzung gemäss Anspruch 8.

14. Verfahren zur photographischen Herstellung von Reliefabbildungen, dadurch gekennzeichnet, dass man ein beschichtetes Substrat gemäss Anspruch 13, bildmässig belichtet und die unbelichteten Anteile danach mit einem Lösungsmittel entfernt.

15. Verwendung von Titanocenen der Formel I gemäss Anspruch 8 als Photoinitiatoren für die Photopolymerisation von äthylenisch ungesättigten Verbindungen.

**Patentansprüche für den Vertragsstaat: AT**

1. Verfahren zur Herstellung von Titanocenen der Formel I'

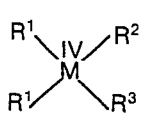

(I')

worin

M für ein vierwertiges Titanatom steht,

beide $R^1$ unabhängig voneinander Cyclopentadienyl$^{\ominus}$, Indenyl$^{\ominus}$ oder beide $R^1$ zusammen für einen Rest der Formel II

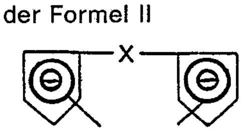

(II)

stehen, worin X $(CH_2)_n$ mit n = 1, 2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_5$–$C_{12}$-Cycloalkyl, $C_6$–$C_{16}$-Aryl oder $C_7$–$C_{16}$-Aralkyl bedeutet, wobei die Reste Cyclopentadienyl$^{\ominus}$, Indenyl$^{\ominus}$ oder der Formel II jeweils unsubstituiert oder durch lineares oder verzweigtes Alkyl, Alkoxy, Alkenyl, Cycloalkyl, Cycloalkenyl, Aryl, Aralkyl, CN, Halogen, Amino oder Aminoalkyl oder quaternisiertem Amino oder quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten,

$$-Q-Y-Q- \qquad \text{(III)}$$

in dem Q für einen carbocyclischen oder heterocyclischen, 5- oder 6-gliedrigen aromatischen Ring steht, wobei die beiden Bindungen zum Titanatom jeweils in Orthostellung zur Y-Gruppe stehen und die andere Orthostellung zu diesen Bindungen jeweils durch ein Fluoratom substituiert ist, wobei die carbocyclischen und heterocyclischen Ringe $R^2$ bzw. Q gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet,

$R^3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CN, $SiR^4_3$ oder $SnR^4_3$ ist oder die Bedeutung von $R^2$ hat, wobei für beide $R^1$ gleich unsubstituiertes Cyclopentadienyl$^{\ominus}$ nur einer der Reste $R^2$ und $R^3$ Pentafluorphenyl ist, mit Ausnahme der Verbindungen Bis-(cyclopentadienyl)-2,2'-octafluorbiphenyltitan und Bis(indenyl)-bis(pentafluorphenyl)-titan, dadurch gekennzeichnet, dass man 1 Mol einer Verbindung der Formel IV

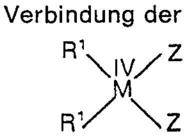

(IV)

worin $R^1$ und $M^{IV}$ die in Anspruch 1 angegebene Bedeutung haben und Z für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ die in Anspruch 1 angegebene Bedeutung hat und $R^3$ Alkinyl, unsubstituiertes oder substituiertes Phenylalkinyl, $N_3$, CN, $SiR^4_3$ oder $SnR^4_3$ bedeutet, und danach die Verbindungen der Formel I in an sich bekannter Weise isoliert.

2. Verfahren gemäss Anspruch 1, worin $R^2$ 2,6-Difluorphen-1-yl oder $R^2$ und $R^3$ zusammen ein Rest der Formel

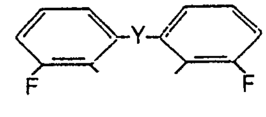

ist, worin Y die zuvor angegebene Bedeutung hat, wobei diese Reste gegebenenfalls weitere Substituenten tragen können, wie sie in Anspruch 1 as Substituenten für $R^2$ bzw. Q angeführt sind.

3. Verfahren gemäss Anspruch 1, worin $R^2$ und $R^3$ die gleiche Bedeutung haben.

4. Verfahren gemäss Anspruch 3, worin $R^2$ und $R^3$ 2,6-Difluorphen-1-yl sind, das 1 bis 3 weitere Substituenten, wie sie in Anspruch 1 als Substituenten für $R^2$ bzw. Q angeführt sind, enthält.

5. Verfahren gemäss Anspruch 1, worin $R^1$ Cyclopentadienyl$^{\ominus}$ oder durch $C_1$–$C_4$-Alkyl substituiertes Cyclopentadienyl$^{\ominus}$ und $R^2$ und $R^3$ ein Rest der Formel

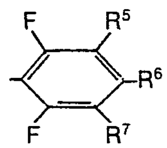

sind, worin $R^5$, $R^6$ und $R^7$ unabhängig voneinander für ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe stehen, wobei nur zwei der Reste $R^5$, $R^6$ und $R^7$ Fluor bedeuten können.

6. Verfahren gemäss Anspruch 5, worin $R^6$ für Fluor, $R^5$ für H, Fluor, Chlor oder Brom und $R^7$ für H, Cl oder Br, oder $R^5$ und $R^7$ für H, Fluor, Chlor oder Brom und $R^6$ für H, Chlor, Br, eine tertiär-Aminogruppe, eine tertiäre Aminoalkylgruppe oder eine quaternäre Ammonium- oder Ammoniumalkylgruppe stehen.

7. Durch Strahlung polymerisierbare Zusammensetzung, enthaltend neben üblichen Zusätzen (a) mindestens eine nichtflüchtige, monomere, oligomere oder polymere Verbindung mit mindestens einer polymerisierbaren äthylenisch ungesättigten Doppelbindung und (b) mindestens ein Titanocen der Formel I als Photoinitiator

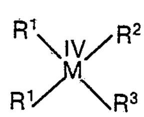
(I)

worin

M für ein vierwertiges Titanatom steht,

bide $R^1$ unabhängig voneinander Cyclopentadienyl$^{\ominus}$, Indenyl$^{\ominus}$ oder beide

$R^1$ zusammen für einen Rest der Formel II

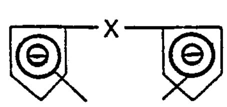
(II)

stehen, worin X $(CH_2)_n$ mit n = 1, 2 oder 3, Alkyliden mit 2 bis 12 C-Atomen, Cycloalkyliden mit 5 bis 7 Ringkohlenstoffatomen, $SiR^4_2$ oder $SnR^4_2$ ist, worin $R^4$ $C_1$–$C_{12}$-Alkyl, $C_5$–$C_{12}$-Cycloalkyl, $C_6$–$C_{16}$-Aryl oder $C_7$-$C_{16}$-Aralkyl bedeutet, wobei die Reste Cyclopentadienyl$^{\ominus}$, Indenyl$^{\ominus}$ oder der Formel II jeweils unsubstituiert oder durch lineares oder verzweigtes Alkyl, Alkoxy, Alkenyl, Cycloalkyl, Cycloalkenyl, Aryl, Aralkyl, Cn, Halogen, Amino oder Aminoalkyl oder quaternisiertem Amino oder quaternisiertem Aminoalkyl substituiert sind,

$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist, oder $R^2$ und $R^3$ zusammen einen Rest der Formel III bedeuten

$$-Q-Y-Q- \qquad (III),$$

in dem Q für einen carbocyclischen oder heterocyclischen 5- oder 6-gliedrigen aromatischen Ring steht, wobei die beiden Bindungen zum Titanatom jeweils in Orthostellung zur Y-Gruppe stehen und die andere Orthostellung zu diesen Bindungen jeweils durch ein Fluoratom substituiert ist, wobei die carbocyclischen und heterocyclischen Ringe $R^2$ bzw. Q gegebenenfalls lineares oder verzweigtes Alkyl, Alkoxy, Cycloalkyl, Aryl, Aralkyl, Hydroxy, Carboxy, Cyano, Halogen, Alkoxycarbonyl, Aminocarbonyl, Amino, quaternisiertes Amino, Aminoalkyl oder quaternisiertes Aminoalkyl als weitere Substituenten tragen können, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet,

$R^3$ Alkinyl, unsubstituiertes oder durch Halogen, tertiär-Amino, $C_1$–$C_6$-Alkyl oder -Alkoxy, Carboxyl, Hydroxy oder Cyano substituiertes Phenylalkinyl, $N_3$, CN, $SiR^4_3$ oder $SnR^4_3$ ist oder die Bedeutung von $R^2$ hat.

8. Zusammensetzung gemäss Anspruch 7, worin die Verbindung (a) ausgewählt ist aus der Gruppe der Ester und Amide ungesättigter Carbonsäuren, der ungesättigten Polyester, Polyamide und Polyurethane, Polybutadien und Polybutadien-Copolymeren, Polyisopren und Polyisopren-Copolymeren.

9. Zusammensetzung gemäss Anspruch 7, worin die Verbindung (a) ein Acryl- oder Methacrylsäureester eines organischen Polyols ist.

10. Zusammensetzung gemäss Anspruch 7, worin in Formel I $R^1$ unsubstituiertes oder durch $C_1$–$C_4$-Alkyl substituiertes Cyclopentadienyl$^{\ominus}$ und $R^2$ und $R^3$ ein Rest der Formel

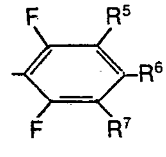

sind, worin $R^5$, $R^6$ und $R^7$ unabhängig voneinander ein Wasserstoffatom, F, Cl, Br, eine tertiäre Aminogruppe, eine quaternäre Ammoniumgruppe, eine tertiäre Aminoalkylgruppe oder eine quaternäre Ammoniumalkylgruppe bedeuten.

11. Zusammensetzung gemäss Anspruch 10, worin $R^5$, $R^6$ und $R^7$ für F stehen.

12. Beschichtetes Substrat, enthaltend als photopolymersierbare Schicht eine Zusammensetzung gemäss Anspruch 7.

13. Verfahren zur photographischen Herstellung von Reliefabbildungen, dadurch gekennzeichnet, dass man ein beschichtetes Substrat gemäss Anspruch 12 bildmässig belichtet und die unbelichteten Anteile danach mit einem Lösungsmittel entfernt.

14. Verwendung von Titanocenen der Formel I gemäss Anspruch 7 als Photoinitiatoren für die Photopolymerisation von äthylenisch ungesättigten Verbindungen.

**Claims for the contracting states BE, CH, DE, FR, GB, IT, LI, NL, SE**

1. A titanocene of the formula I′

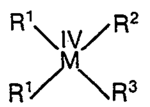

(I′)

wherein

M is a tetravalent titanium atom,

both symbols $R^1$ independently of one another are cyclopentadienyl$^{\ominus}$, indenyl$^{\ominus}$ or both symbols $R^1$ together are a radical of the formula II

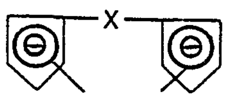

(II)

wherein X is $(CH_2)_n$ in which n is 1, 2 or 3, alkylidene having 2 to 12 C atoms, cycloalkylidene having 5 to 7 ring carbon atoms, $SiR^4_2$ or $SnR^4_2$, in which $R^4$ is $C_1$–$C_{12}$alkyl, $C_5$–$C_{12}$cycloalkyl, $C_6$–$C_{16}$aryl or $C_7$–$C_{16}$-aralkyl, the radicals cyclopentadienyl$^{\ominus}$, indenyl$^{\ominus}$ or of the formula II being in each case unsubstituted or substituted by linear or branched alkyl, alkoxy, alkenyl, cycloalkyl, cycloalkenyl, aryl, aralkyl, CN, halogen, amino or aminoalkyl or quaternized amino or quaternized aminoalkyl,

$R^2$ is a 6-membered carbocyclic or 5- or 6-membered heterocyclic aromatic ring which is substituted by fluorine atoms in at least one of the two ortho-positions relative to the metal-carbon bond, or $R^2$ and $R^3$ together are a radical of the formula III

$$-Q-Y-Q- \quad \text{(III)}$$

in which Q is a carbocyclic or heterocyclic 5- or 6-membered aromatic ring, each of the two bonds to the titanium atom being in the orthoposition relative to the Y group and the other ortho-position relative to these bonds being substituted in each case by a fluorine atom, and where the carbocyclic and heterocyclic ring $R^2$ or Q can carry optionally linear or branched alkyl, alkoxy, cycloalkyl, aryl, aralkyl, hydroxyl carboxyl, cyano, halogen, alkoxycarbonyl, aminocarbonyl, amino, quaternized amino, aminoalkyl or quaternized aminoalkyl as further substituents, and Y is $CH_2$, alkylidene having 2 to 12 C atoms, cycloalkylidene having 5 to 7 ring carbon atoms, a direct bond, $NR^4$, O, S, SO, $SO_2$, CO, $SiR^4_2$ or $SnR^4_2$,

$R^3$ is alkynyl, phenylalkynyl which is unsubstituted or substituted by halogen, tertiary amino, $C_1$–$C_6$alkyl or $C_1$–$C_6$alkoxy, carboxyl, hydroxyl or cyano, or is $N_3$, CN, $SiR^4_3$ or $SnR^4_3$ or has the meaning of $R^2$, where, if both symbols $R^1$ are unsubstituted cyclopentadienyl$^{\ominus}$, only one of the radicals $R^2$ and $R^3$ is pentafluorophenyl; with the exception of the compounds bis-(cyclopentadienyl)-2,2′-octafluorobiphenyltitanium and bis(indenyl)-bis(pentafluorphenyl)-titanium.

2. A titanocene according to claim 1, wherein $R^2$ is 2,6-difluorophen-1-yl, or $R^2$ and $R^3$ together are a radical of the formula

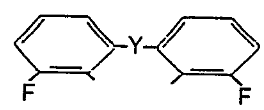

wherein Y is as defined above, it being possible for these radicals to carry further substituents, as are listed in claim 1 as substituents for $R^2$ or Q.

3. A titanocene according to claim 1, wherein $R^2$ and $R^3$ have the same meaning.

4. A titanocene according to claim 3, wherein $R^2$ and $R^3$ are 2,6-difluoro-phen-1-yl which contains 1 to 3 further substituents, as are listed in claim 1 as substituents for $R^2$ or Q.

5. A titanocene according to claim 1, wherein $R^1$ is cyclopentadienyl$^{\ominus}$ or $C_1$–$C_4$alkyl-substituted cyclopentadienyl$^{\ominus}$, and $R^2$ and $R^3$ are a radical of the formula

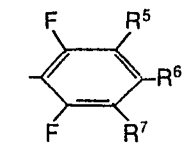

wherein $R^5$, $R^6$ and $R^7$ independently of one another are a hydrogen atom, F, Cl, Br, a tertiary amino group, a quaternary ammonium group, a tertiary aminoalkyl group or a quaternary ammoniumalkyl group, where only two of the radicals $R^5$, $R^6$ and $R^7$ can be fluorine.

6. A titanocene according to claim 5, wherein $R^6$ is fluorine, $R^5$ is H, fluorine, chlorine or bromine, and $R^7$ is H, Cl or Br, or $R^5$ and $R^7$ are H, fluorine, chlorine or bromine and $R^6$ is H, chlorine, Br, a tertiary amino group, a tertiary aminoalkyl group or a quaternary ammonium or ammoniumalkyl group.

7. A process for the preparation of a titanocene of the formula I′ according to claim 1, which comprises reacting 1 mole of a compound of the formula

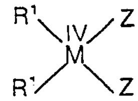

(IV)

wherein $R^1$ and $M^{IV}$ are as defined in claim 1 and Z is halogen, in particular chlorine, either with 1 mole of $LiR^2$ or $LiR^3$ and subsequently with 1 mole of $LiR^3$ or $LiR^2$, or with 2 moles of $LiR^2$, where $R^2$ and $R^4$ are as defined in claim 1 and $R^3$ is alkynyl, phenylalkynyl which is unsubstituted or substituted by halogen, tertiary amino, $C_1$–$C_6$alkyl, $C_1$–$C_6$alkoxy, carboxyl, hydroxyl or cyano, or is $N_3$, CN, $SiR^4_3$ or $SnR^4_3$, and subsequently isolating the compound of the formula I in a manner known per se.

8. A composition which can be polymerized by irradiation and which contains (a) at least one non-volatile monomeric, oligomeric or polymeric compound having at least one polymerizable ethylenically unsaturated double bond and (b) at least one titanocene of the formula I as photoinitiator

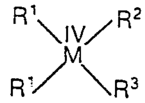
(I)

wherein M is a tetravalent titanium atom, both symbols $R^1$ independently of one another are cyclopentadienyl$^{\ominus}$, indenyl$^{\ominus}$ or both symbols $R^1$ together are a radical of the formula II

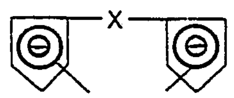
(II)

wherein X is $(CH_2)_n$ in which n is 1, 2 or 3, alkylidene having 2 to 12 C atoms, cycloalkylidene having 5 to 7 ring carbon atoms, $SiR^4_2$ or $SnR^4_2$, in which $R^4$ is $C_1$–$C_{12}$alkyl, $C_5$–$C_{12}$cycloalkyl, $C_6$–$C_{16}$aryl or $C_7$–$C_{16}$-aralkyl, the radicals cyclopentadienyl$^{\ominus}$, indenyl$^{\ominus}$ or of the formula II being in each case unsubstituted or substituted by linear or branched alkyl, alkoxy, alkenyl, cycloalkyl, cycloalkenyl, aryl, aralkyl, CN, halogen, amino or aminoalkyl or quaternized amino or quaternized aminoalkyl,

$R^2$ is a 6-membered carbocyclic or 5- or 6-membered heterocyclic aromatic ring which is substituted by fluorine atoms in at least one of the two ortho-positions relative to the metal-carbon bond, or $R^2$ and $R^3$ together are a radical of the formula III

$$-Q-Y-Q- \qquad (III)$$

in which Q is a carbocyclic or heterocyclic 5- or 6-membered aromatic ring, each of the two bonds to the titanium atom being in the ortho-position relative to the Y group and the other ortho-position relative to these bonds being substituted by a fluorine atom, and where the carbocyclic and heterocyclic ring $R^2$ or Q can carry optionally linear or branched alkyl, alkoxy, cycloalkyl, aryl, aralkyl, hydroxyl carboxyl, cyano, halogen, alkoxycarbonyl, aminocarbonyl, amino, quaternized amino, aminoalkyl or quaternized aminoalkyl as further substituents, and Y is $CH_2$, alkylidene having 2 to 12 C atoms, cycloalkylidene having 5 to 7 ring carbon atoms, a direct bond, $NR^4$, O, S, SO, $SO_2$, CO, $SiR^4_2$ or $SnR^4_3$,

$R^3$ is alkynyl, phenylalkynyl which is unsubstituted or substituted by halogen, tertiary amino, $C_1$–$C_6$alkyl or $C_1$–$C_6$alkoxy, carboxyl, hydroxyl or cyano, or is $N_3$, CN, $SiR^4_3$ or $SnR^4_3$ or has the meaning of $R^2$,

together with conventional ingredients.

9. A composition according to claim 8, wherein the compound (a) is selected from the group of the esters and amides of unsaturated carboxylic acids, unsaturated polyesters, polyamides and polyurethanes, polybutadiene and polybutadiene copolymers, polyisoprene and polyisoprene copolymers.

10. A composition according to claim 8, wherein the compound (a) is an acrylate or methacrylate of an organic polyol.

11. A composition according to claim 8, wherein $R^1$ in formula I is unsubstituted or $C_1$–$C_4$alkyl-substituted cyclopentadienyl$^{\ominus}$ and $R^2$ and $R^3$ are a radical of the formula

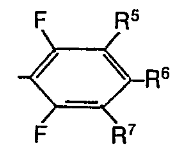

wherein $R^5$, $R^6$ and $R^7$ independently of one another are a hydrogen atom, F, Cl, Br, a tertiary amino group, a quaternary ammonium group, a tertiary aminoalkyl group or a quaternary ammoniumalkyl group.

12. A composition according to claim 11, wherein $R^5$, $R^6$ and $R^7$ are F.

13. A coated substrate which contains a composition according to claim 8 as photopolymerizable layer.

14. A process for the photographic production of relief images, which comprises exposing a coated substrate according to claim 13 imagewise and subsequently removing the non-exposed areas with a solvent.

15. Use of a titanocene of the formula I according to claim 8 as photoinitiator for the photopolymerization of ethylenically unsaturated compounds.

**Claims for the contracting state: AT**

1. A process for the preparation of a titanocene of the formula I′

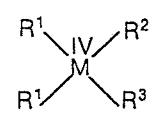
(I′)

wherein

M is a tetravalent titanium atom,

both symbols $R^1$ independently of one another are cyclopentadienyl$^{\ominus}$,

indenyl$^{\ominus}$ or both symbols $R^1$ together are a radical of the formula II

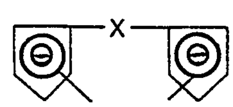
(II)

wherein X is $(CH_2)_n$ in which n is 1, 2 or 3, alkylidene having 2 to 12 C atoms, cycloalkylidene having 5 to 7 ring carbon atoms, $SiR^4_2$ or $SnR^4_2$, in which $R^4$ is $C_1$–$C_{12}$alkyl, $C_5$–$C_{12}$cycloalkyl, $C_6$–$C_{16}$aryl or $C_7$–$C_{16}$-aralkyl, the radicals cyclopentadienyl$^{\ominus}$, indenyl$^{\ominus}$ or of the formula II being in each case unsubstituted or substituted by linear or branched alkyl, alkoxy, alkenyl, cycloalkyl, cycloalkenyl, aryl, aralkyl, CN, halogen,

amino or aminoalkyl or quaternized amino or quaternized aminoalkyl,

$R^2$ is a 6-membered carbocyclic or 5- or 6-membered heterocyclic aromatic ring which is substituted by fluorine atoms in at least one of the two ortho-positions relative to the metal-carbon bond, or $R^2$ and $R^3$ together are a radical of the formula III

$$-Q-Y-Q- \quad (III)$$

in which Q is a carbocyclic or heterocyclic 5- or 6-membered aromatic ring, each of the two bonds to the titanium atom being in the ortho-position relative to the Y group and the other ortho-position relative to these bonds being substituted in each case by a fluorine atom, ad where the carbocyclic and heterocyclic ring $R^2$ or Q can carry optionally linear or branched alkyl, alkoxy, cycloalkyl, aryl, aralkyl, hydroxyl carboxyl, cyano, halogen, alkoxycarbonyl, aminocarbonyl, amino, quaternized amino, aminoalkyl or quaternized aminoalkyl as further substituents, and Y is $CH_2$, alkylidene having 2 to 12 C atoms, cycloalkylidene having 5 to 7 ring carbon atoms, a direct bond, $NR^4$, O, S, SO, $SO_2$, CO, $SiR^4_2$ or $SnR^4_2$,

$R^3$ is alkynyl, phenylalkynyl which is unsubstituted or substituted by halogen, tertiary amino, $C_1$–$C_6$alkyl or $C_1$–$C_6$alkoxy, carboxyl, hydroxyl or cyano, or is $N_3$, CN, $SiR^4_3$ or $SnR^4_3$ or has the meaning of $R^2$, where, if both symbols $R^1$ are unsubstituted cyclopentadienyl$^\ominus$, only one of the radicals $R^2$ and $R^3$ is pentafluorophenyl; with the exception of the compounds bis-(cyclopentadienyl)-2,2′-octafluorobiphenyltitanium and bis(indenyl)-bis(pentafluorophenyl)-titanium, which comprises reacting 1 mole of a compound of the formula IV

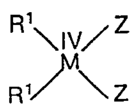

(IV)

wherein $R^1$ and $M^{IV}$ are as defined in claim 1 and Z is halogen, in particular chlorine, either with 1 mole of $LiR^2$ or $LiR^3$ and subsequently with 1 mole of $LiR^3$ or $LiR^2$, or with 2 moles of $LiR^2$, where $R^2$ is as defined in claim 1 and $R^3$ is alkynyl, unsubstituted or substituted phenylalkynyl, $N_3$, CN, $SiR^4_3$ or $SnR^4_3$, and subsequently isolating the compound of the formula I in a manner known per se.

2. A process according to claim 1, wherein $R^2$ is 2,6-difluorophen-1-yl, or $R^2$ and $R^3$ together are a radical of the formula

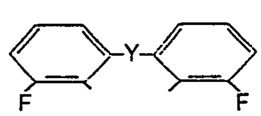

wherein Y is as defined above, it being possible for these radicals to carry further substituents, as are listed in claim 1 as substituents for $R^2$ or Q.

3. A process according to claim 1, wherein $R^2$ and $R^3$ have the same meaning.

4. A process according to claim 3, wherein $R^2$ and $R^3$ are 2,6-difluoro-phen-1-yl which contains 1 to 3 further substituents, as are listed in claim 1 as substituents for $R^2$ or Q.

5. A process according to claim 1, wherein $R^1$ is cyclopentadienyl$^\ominus$ or $C_1$–$C_4$alkyl-substituted cyclopentadienyl$^\ominus$, and $R^2$ and $R^3$ are a radical of the formula

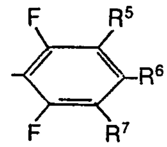

wherein $R^5$, $R^6$ and $R^7$ independently of one another are a hydrogen atom, F, Cl, Br, a tertiary amino group, a quaternary ammonium group, a tertiary aminoalkyl group or a quaternary ammoniumalkyl group, where only two of the radicals $R^5$, $R^6$ and $R^7$ can be fluorine.

6. A process according to claim 5, wherein $R^6$ is fluorine, $R^5$ is H, fluorine, chlorine or bromine, and $R^7$ is H, Cl or Br, or $R^5$ and $R^7$ are H, fluorine, chlorine or bromine and $R^6$ is H, chlorine, Br, a tertiary amino group, a tertiary aminoalkyl group or a quaternary ammonium or ammoniumalkyl group.

7. A composition which can be polymerized by irradiation and which contains (a) at least one non-volatile monomeric, oligomeric or polymeric compound having at least one polymerizable ethylenically unsaturated double bond and (b) at least one titanocene of the formula I as photoinitiator

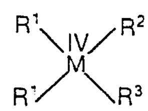

(I)

wherein

M is a tetravalent titanium atom,

both symbols $R^1$ independently of one another are cyclopentadienyl$^\ominus$, indenyl$^\ominus$ or both symbols $R^1$ together are a radical of the formula II

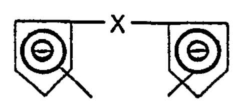

(II)

wherein X is $(CH_2)_n$ in which n is 1, 2 or 3, alkylidene having 2 to 12 C atoms, cycloalkylidene having 5 to 7 ring carbon atoms, $SiR^4_2$ or $SnR^4_2$, in which $R^4$ is $C_1$–$C_{12}$alkyl, $C_5$–$C_{12}$cycloalkyl, $C_6$–$C_{16}$aryl or $C_7$–$C_{16}$-aralkyl, the radicals cyclopentadienyl$^\ominus$, indenyl$^\ominus$ or of the formula II being in each case unsubstituted or substituted by linear or branched alkyl, alkoxy, alkenyl, cycloalkyl, cycloalkenyl, aryl, aralkyl, CN, halogen, amino or aminoalkyl or quaternized amino or quaternized aminoalkyl,

$R^2$ is a 6-membered carbocyclic or 5- or 6-membered heterocyclic aromatic ring which is substituted by fluorine atoms in at least one of the two ortho-positions relative to the metal-carbon bond, or $R^2$ and $R^3$ together are a radical of the formula III

$$-Q-Y-Q- \quad (III)$$

in which Q is a carbocyclic or heterocyclic 5- or 6-membered aromatic ring, each of the two bonds to the titanium atom being in the ortho-position relative to the Y group and the other ortho-position relative to these bonds being substituted by a fluorine atom, and where the carbocyclic and heterocyclic ring $R^2$ or Q can carry optionally linear or branched alkyl, alkoxy, cycloalkyl, aryl, aralkyl, hydroxyl carboxyl, cyano, halogen, alkoxycarbonyl, aminocarbonyl, amino, quaternized amino, aminoalkyl or quaternized aminoalkyl as further substituents, and Y is $CH_2$, alkylidene having 2 to 12 C atoms, cycloalkylidene having 5 to 7 ring carbon atoms, a direct bond, $NR^4$, O, S, SO, $SO_2$, CO, $SiR^4_2$ or $SnR^4_3$,

$R^3$ is alkynyl, phenylalkynyl which is unsubstituted or substituted by halogen, tertiary amino, $C_1$–$C_6$alkyl or $C_1$–$C_6$alkoxy, carboxyl, hydroxyl or cyano, or is $N_3$, CN, $SiR^4_3$ or $SnR^4_3$ or has the meaning of $R^2$,
together with conventional ingredients.

8. A composition according to claim 7, wherein the compound (a) is selected from the group of the esters and amides of unsaturated carboxylic acids, unsaturated polyesters, polyamides and polyurethanes, polybutadiene and polybutadiene copolymers, polyisoprene and polyisoprene copolymers.

9. A composition according to claim 7, wherein the compound (a) is an acrylate or methacrylate of an organic polyol.

10. A composition according to claim 7, wherein $R^1$ in formula I is unsubstituted or $C_1$–$C_4$alkyl-substituted cyclopentadienyl$^\ominus$ and $R^2$ and $R^3$ are a radical of the formula

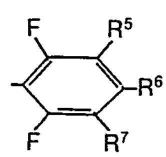

wherein $R^5$, $R^6$ and $R^7$ independently of one another are a hydrogen atom, F, Cl, Br, a tertiary amino group, a quaternary ammonium group, a tertiary aminoalkyl group or a quaternary ammoniumalkyl group.

11. A composition according to claim 10, wherein $R^5$, $R^6$ and $R^7$ are F.

12. A coated substrate which contains a composition according to claim 7 as photopolymerizable layer.

13. A process for the photographic production of relief images, which comprises exposing a coated substrate according to claim 12 imagewise and subsequently removing the non-exposed areas with a solvent.

14. Use of a titanocene of the formula I according to claim 7 as photoinitiator for the photopolymerization of ethylenically unsaturated compounds.

**Revendications pour les Etats contractants: BE, CH, DE, FR, GB, IT, LI, NL, SE**

1. Titanocènes répondant à la formule I':

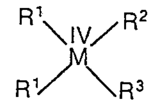
(I)

dans laquelle:

M représente un atome de titane quadrivalent,
les deux $R^1$ représentent chacun, indépendamment l'un de l'autre, un radical cyclopentadiényle$^\ominus$ ou indényle$^\ominus$, ou forment ensemble un radical répondant à la formule II:

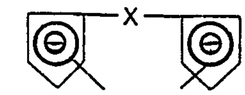
(II)

dans laquelle X représente un radical $(CH_2)_n$ dont l'indice n est égal à 1, à 2 ou à 3, un alkylidène contenant de 2 à 12 atomes de carbone, un cycloalkylidène contenant de 5 à 7 atomes de carbones, un radical $SiR_2^4$ ou un radical $SnR_2^4$, le symbole $R_4$ désignant un alkyle en $C_1$–$C_{12}$, un cycloalkyle en $C_5$–$C_{12}$, un aryle en $C_6$–$C_{16}$ ou un aralkyle en $C_7$–$C_{16}$, les radicaux cyclopentadiényle$^\ominus$ et indényle$^\ominus$ ainsi que le radical de formule II pouvant chacun être dépourvus de substituants ou porter un alkyle linéaire ou ramifié, un alcoxy, un alcényle, un cycloalkyle, un cycloalcényle, un aryle, un aralkyle, un cyano, un halogène, un amino, un aminoalkyle, un amino quaternisé ou un aminoalkyle quaternisé,

$R^2$ représente un noyau aromatique carbocyclique hexagonal ou hétérocyclique pentagonal ou hexagonal, qui, en au moins l'une des deux positions ortho par rapport à la liaison métal-carbone, porte un atome de fluor, ou $R^2$ et $R^3$ forment ensemble un radical répondant à la formule III:

$$-Q-Y-Q- \qquad \text{(III)}$$

dans laquelle:

Q représente un noyau aromatique carbocyclique ou hétérocyclique contenant 5 ou 6 maillons, les deux liaisons à l'atome du titane étant chacune en position ortho par rapport à Y, et, sur chacun des deux noyaux, l'autre position ortho portant un atome de fluor, les noyaux carbocycliques et hétérocycliques $R^2$ et Q portant éventuellement, comme substituants supplémentaires, un alkyle linéaire ou ramifié, un alcoxy, un cycloalkyle, un aryle, un aralkyle, un hydroxy, un carboxy, un cyano, un halogène, un alcoxycarbonyle, un amino-carbonyle, un amino, un amino quaternisé, un amino-alkyle ou un amino-alkyle quaternisé, et

Y représente $CH_2$, un alkylidène en $C_2$–$C_{12}$, un cyclo-alkylidène en $C_5$–$C_7$, une liaison directe, $NR^4$, O, S, SO, $SO_2$, CO, $SiR_2^4$ ou $SnR_2^4$,
et

$R^3$ représente un alcynyle, un phénylalcynyle non substitué ou porteur d'un halogène, d'un amino tertiaire, d'un alkyle en $C_1$–$C_6$, d'un alcoxy en $C_1$–$C_6$, d'un carboxy, d'un hydroxy ou d'un

cyano, $N_3$, CN, $SiR_3{}^4$ ou $SnR_3{}^4$, ou a la signification de $R^2$,

avec la restriction que, dans le cas où les deux symboles

$R^1$ représentent chacun un cyclopentadiényle$^{\ominus}$ non substitué, un seulement des symboles $R^2$ et $R^3$ puisse être un radical pentafluorophényle, et à l'exception du bis-(cyclo-pentadiényl)-(octafluoro-biphénylylène-2,2')-titane et du bis-(indényl)-bis-(pentafluorophényl)-titane.

2. Titanocènes selon la revendication 1 dans lesquels $R^2$ représente un radical difluoro-2,6 phényle ou $R^2$ et $R^3$ forment ensemble un radical répondant à la formule:

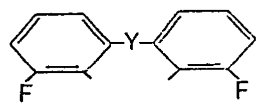

dans laquelle Y a la signification indiquée ci-dessus, ces radicaux pouvant porter éventuellement des substituants supplémentaires tels que ceux qui ont été indiqués à la revendication 1 comme substituants pour $R^2$ ou Q.

3. Titanocènes selon la revendication 1 dans lesquels $R^2$ et $R^3$ ont la même signification.

4. Titanocènes selon la revendication 3 dans lesquels $R^2$ et $R^3$ représentent chacun un radical difluoro-2,6 phényle qui peut porter de 1 à 3 substituants supplémentaires tels que ceux qui ont été indiqués à la revendication 1 comme substituants pour $R^2$ ou Q.

5. Titanocènes selon la revendication 1 dans lesquels $R^1$ représente un radical cyclopentadiényle$^{\ominus}$ ou un radical cyclopentadiényle$^{\ominus}$ porteur d'un alkyle en $C_1$–$C_4$, et $R^2$ et $R^3$ représentent chacun un radical répondant à la formule:

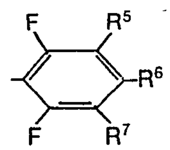

dans laquelle $R^5$, $R^6$ et $R^7$ représentent chacun, indépendamment les uns des autres, un atome d'hydrogène, F, Cl, Br, un radical amino tertiaire, un radical ammonium quaternaire, un radical aminoalkyle tertiaire ou un radical ammonio-alkyle quaternaire, deux seulement des symboles $R^5$, $R^6$ et $R^7$ pouvant représenter le fluor.

6. Titanocènes selon la revendication 5 dans lesquels $R^6$ représente le fluor, $R^5$ représente H, le fluor, le chlore ou le brome et $R_7$ représente H, Cl ou Br, ou $R^5$ et $R^7$ représentent chacun H, le fluor, le chlore ou le brome et $R^6$ représente H, le chlore, Br, un radical amino tertiaire, un radical aminoalkyle tertiaire ou un radical ammonium ou ammonioalkyle quaternaire.

7. Procédé pour préparer des titanocènes de formule I' selon la revendication 1, procédé caractérisé en ce qu'on fait réagir 1 mol d'un composé répondant à la formule IV:

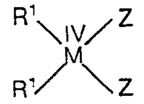

(IV)

dans laquelle $R^1$ et $M^{IV}$ ont les significations données à la revendication 1, et Z représente un halogène, en particulier le chlore, soit avec 1 mol de $LiR^2$ ou de $LiR^3$, puis avec 1 mol de $LiR^3$ ou de $LiR^2$, soit avec 2 mol de $LiR^2$, les symboles $R^2$ et $R^4$ ayant les significations données à la revendication 1 et $R^3$ représentant un alcynyle, un phénylalcynyle non substitué ou porteur d'un halogène, d'un amino tertiaire, d'un alkyle en $C_1$–$C_6$, d'un alcoxy en $C_1$–$C_6$, d'un carboxy, d'un hydroxy ou d'un cyano, $N_3$, CN, $SiR_3{}^4$ ou $SnR_3{}^4$, puis on isole de manière connue les composés de formule I.

8. Composition polymérisable par un rayonnement, composition qui, en plus d'additifs usuels, contient:

(a) au moins un composé monomère, oligomère ou polymère non volatile qui contient au moins une double liaison éthylénique polymérisable et

(b) au moins un titanocène de formule I comme photo-amorceur:

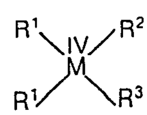

(I)

formule dans laquelle:

M représente un atome de titane quadrivalent,

les deux $R^1$ représentent chacun, indépendamment l'un de l'autre, un radical cyclopentadiényle$^{\ominus}$ ou indényle$^{\ominus}$, ou forment ensemble un radical répondant à la formule II:

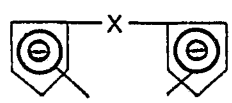

(II)

dans laquelle X représente un radical $(CH_2)_n$ dont l'indice n est égal à 1, à 2 ou à 3, un alkylidène contenant de 2 à 12 atomes de carbone, un cycloalkylidène contenant de 5 à 7 atomes de carbones, un radical $SiR_2{}^4$ ou un radical $SnR_2{}^4$, le symbole $R_4$ désignant un alkyle en $C_1$–$C_{12}$, un cycloalkyle en $C_5$–$C_{12}$, un aryle en $C_6$–$C_{16}$ ou un aralkyle en $C_7$–$C_{16}$,

les radicaux cyclopentadiényle$^{\ominus}$ et indényle$^{\ominus}$ ainsi que le radical de formule II pouvant chacun être dépourvus de substituants ou porter un alkyle linéaire ou ramifié, un alcoxy, un alcényle, un cycloalkyle, un cycloalcényle, un aryle, un aralkyle, un cyano, un halogène, un amino, un aminoalkyle, un amino quaternisé ou un aminoalkyle quaternisé,

$R^2$ représente un noyau aromatique carbocyclique hexagonal ou hétérocyclique pentagonal ou hexagonal, qui, en au moins l'une des deux positions ortho par rapport à la liaison métal-carbone, porte un atome de fluor, ou $R^2$ et $R^3$ forment ensemble un radical répondant à la formule III:

$$-Q-Y-Q- \qquad \text{(III)}$$

dans laquelle:

Q représente un oyau aromatique carbocyclique ou hétérocyclique contenant 5 ou 6 maillons, les deux liaisons à l'atome de titane étant chacune en position ortho par rapport à Y, et, sur chacun

des deux noyaux, l'autre position ortho portant un atome de fluor, les noyaux carbocycliques et hétérocycliques $R^2$ et Q portant éventuellement, comme substituants supplémentaires, un alkyle linéaire ou ramifié, un alcoxy, un cycloalkyle, un aryle, un aralkyle, un hydroxy, un carboxy, un cyano, un halogène, un alcoxycarbonyle, un aminocarbonyle, un amino, un amino quaternisé, un aminoalkyle ou un amino-alkyle quaternisé, et

Y représente $CH_2$, un alkylidène en $C_2$–$C_{12}$, un cyclo-alkylidène en $C_5$–$C_7$, une liaison directe, $NR^4$, O, S, SO, $SO_2$, CO, $SiR_2^4$ ou $SnR_2^4$,
et

$R^3$ représente un alcynyle, un phénylalcynyle non substitué ou porteur d'un halogène, d'un amino tertiaire, d'un alkyle en $C_1$–$C_6$, d'un alcoxy en $C_1$–$C_6$, d'un carboxy, d'un hydroxy ou d'un cyano, $N_3$, CN, $SiR_3^4$ ou $SnR_3^4$, ou a la signification de $R^2$.

9. Composition selon la revendication 8 dans laquelle le composé (a) est choisi dans l'ensemble constitué par les esters et les amides d'acides carboxyliques insaturés, les polyesters, les polyamides et les polyuréthannes insaturés, le polybutadiène, les copolymères du polybutadiène, le poly-isoprène et les copolymères du poly-isoprène.

10. Composition selon la revendication 8 dans laquelle le composé (a) est un ester acrylique ou méthacrylique d'un polyol organique.

11. Composition selon la revendication 8 qui contient un composé de formule I dans laquelle $R^1$ représente un radical cyclopentadiényle$^{\ominus}$ non substitué ou porteur d'un alkyle en $C_1$–$C_4$, et $R^2$ et $R^3$ représentent chacun un radical répondant à la formule:

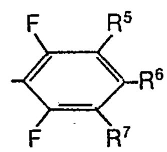

dans laquelle $R^5$, $R^6$ et $R^7$ représentent chacun, indépendamment les uns des autres, un atome d'hydrogène, F, Cl, Br, un radical amino tertiaire, un radical ammonium quaternaire, un radical aminoalkyle tertiaire ou un radical ammonio-alkyle quaternaire.

12. Composition selon la revendication 11 dans laquelle $R^5$, $R^6$ et $R^7$ représentent chacun F.

13. Substrat revêtu qui comporte, comme couche photopolymérisable, une composition selon la revendication 8.

14. Procédé pour créer des images photographiques en relief, procédé caractérisé en ce qu'on irradie conformément à une image un substrat revêtu selon la revendication 13 et on élimine ensuite au moyen d'un solvant les parties qui n'ont pas été touchées par le rayonnement.

15. Application de titanocènes de formule I selon la revendication 8 comme photo-amorceurs pour la photo-polymérisation de composés éthyléniques.

**Revendications pour l'Etat Contractant: AT**

1. Procédé pour préparer des titanocènes répondant à la formule I':

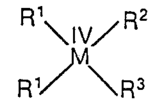

(I')

dans laquelle:

M représente un atome de titane quadrivalent,

les $R^1$ représentent chacun, indépendamment l'un de l'autre, un radical cyclopentadiényle$^{\ominus}$ ou indényle$^{\ominus}$, ou forment ensemble un radical répondant à la formule II:

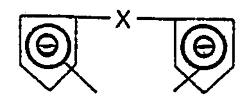

(II)

dans laquelle X représente un radical $(CH_2)_n$ dont l'indice n est égal à 1, à 2 ou à 3, un alkylidène contenant de 2 à 12 atomes de carbone, un cycloalkylidène contenant de 5 à 7 atomes de carbone, un radical $SiR_2^4$ ou un radical $SnR_2^4$, le symbole $R^4$ désignant un alkyle en $C_1$–$C_{12}$, un cycloalkyle en $C_5$–$C_{12}$, un aryle en $C_6$–$C_{16}$, ou un aralkyle en $C_7$–$C_{16}$,

les radicaux cyclopentadiényle$^{\ominus}$ et indényle$^{\ominus}$ ainsi que le radical de formule II pouvant chacun être dépourvus de substituants ou porter un alkyle linéaire ou ramifié, un alcoxy, un alcényle, un cycloalkyle, un cycloalcényle, un aryle, un aralkyle, un cyano, un halogène, un amino, un aminoalkyle, un amino quaternisé ou un aminoalkyle quaternisé,

$R^2$ représente un noyau aromatique carbocyclique hexagonal ou hétérocyclique pentagonal ou hexagonal, qui en au moins l'une des deux positions ortho par rapport à la liaison métal-carbone, porte un atome de fluor, ou $R^2$ et $R^3$ forment ensemble un radical répondant à la formule III:

$$-Q-Y-Q- \qquad (III)$$

dans laquelle:

Q représente un noyau aromatique carbocyclique ou hétérocyclique contenant 5 ou 6 maillons, les deux liaisons à l'atome de titane étant chacune en position ortho par rapport à Y, et, sur chacun des deux noyaux, l'autre position ortho portant un atome de fluor, les noyaux carbocycliques et hétérocycliques $R^2$ et Q portant éventuellement, comme substituants supplémentaires, un alkyle linéaire ou ramifié, un alcoxy, un cycloalkyle, un aryle, un aralkyle, un hydroxy, un carboxy, un cyano, un halogène, un alcoxycarbonyle, un aminocarbonyle, un amino, un amino quaternisé, un amino-alkyle ou un amino-alkyle quaternisé, et

Y représente $CH_2$, un alkylidène en $C_2$–$C_{12}$, un cyclo-alkylidène en $C_5$–$C_7$, une liaison directe, $NR^4$, O, S, SO, $SO_2$, CO, $SiR_2^4$ ou $SnR_2^4$,
et

$R^3$ représente un alcynyle, un phénylalcynyle non substitué ou porteur d'un halogène, d'un amino tertiaire, d'un alkyle en $C_1$–$C_6$, d'un alcoxy

en $C_1$–$C_6$, d'un carboxy, d'un hydroxy ou d'un cyano, $N_3$, CN, $SiR_3^4$ ou $SnR_3^4$, ou a la signification de $R^2$,
avec la restriction que, dans le cas où les deux symboles
$R^1$ représentent chacun un cyclopentadiényle$^\ominus$ non substitué, un seulement des symboles $R^2$ et $R^3$ puisse être un radical pentafluorophényle, et à l'exception du bis-(cyclopentadiényl)-(octafluorobiphénylylène-2,2')-titane et du bis-(indényl)-bis-(pentafluorophényl)-titane,
procédé caractérisé en ce qu'on fait réagir 1 mol d'un composé répondant à la formule IV:

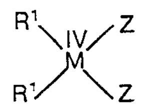

(IV)

dans laquelle $R^1$ et $M^{IV}$ ont les significations qui leur ont été données dans cette revendication et Z représente un halogène, en particulier le chlore, soit avec 1 mol de $LiR^2$ ou de $LiR^3$, puis avec 1 mol de $LiR^3$ ou $LiR^2$, soit avec 2 mol de $LiR^2$, le symbole $R^2$ ayant la signification qui lui a été donnée dans cette même revendication et $R^3$ représentant un alcynyle, un phénylalcynyle non substitué ou substitué, $N_3$, CN, $SiR_3^4$ ou $SnR_3^4$, puis on isole de manière connue les composés de formule I.

2. Procédé selon la revendication 1 dans lequel $R^2$ représente un radical difluoro-2,6-phényle, ou $R^2$ et $R^3$ forment ensemble un radical répondant à la formule:

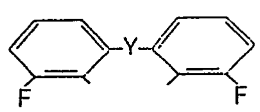

dans laquelle Y a la signification qui lui a été donnée ci-dessus, ces radicaux pouvant éventuellement porter des substituants supplémentaires tels que ceux qui ont été indiqués à la revendication 1 comme substituants pour $R^2$ ou Q.

3. Procédé selon la revendication 1 dans lequel $R^2$ et $R^3$ ont la même signification.

4. Procédé selon la revendication 3 dans lequel $R^2$ et $R^3$ représentent chacun un radical difluoro-2,6 phényle qui porte de 1 à 3 substituants supplémentaires tels que ceux qui ont été indiqués à la revendication 1 comme substituants pour $R^2$ ou Q.

5. Procédé selon la revendication 1 dans lequel $R^1$ représente un radical cyclopentadiényle$^\ominus$ ou un radical cyclopentadiényle$^\ominus$ porteur d'un alkyle en $C_1$–$C_4$, et $R^2$ et $R^3$ représentent chacun un radical répondant à la formule:

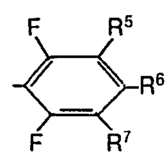

dans laquelle $R^5$, $R^6$ et $R^7$ représentent chacun, indépendamment les uns des autres, un atome d'hydrogène, F, Cl, Br, un radical amino tertiaire, un radical ammonium quaternaire, un radical aminoalkyle tertiaire ou un radical ammonio-alkyle quaternaire, deux seulement des symboles $R^5$, $R^6$ et $R^7$ pouvant représenter le fluor.

6. Procédé selon la revendication 5 dans lequel $R^6$ représente le fluor, $R^5$ représente H, le fluor, le chlore ou le brome et $R^7$ représente H, Cl ou Br, ou $R^5$ et $R^7$ représentent chacun H, le fluor, le chlore ou le brome et $R^6$ représente H, le chlore, Br, un radical amino tertiaire, un radical aminoalkyle tertiaire ou un radical ammonium ou ammonioalkyle quaternaire.

7. Composition polymérisable par un rayonnement, composition qui, en plus d'additifs usuels, contiennent:

(a) au moins un composé monomère, oligomère ou polymère non volatil qui contient au moins une double liaison éthylénique polymérisable et

(b) au moins un titanocène de formule I comme photo-amorceur:

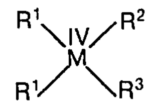

(I)

formule dans laquelle

M représente un atome de titane quadrivalent,

les deux $R^1$ représentent chacun, indépendamment l'un de l'autre, un radical cyclopentadiényle$^\ominus$ ou indényle$^\ominus$, ou forment ensemble un radical répondant à la formule II:

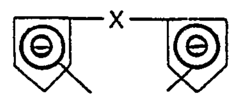

(II)

dans laquelle X représente un radical $(CH_2)_n$ dont l'indice n est égal à 1, à 2 ou à 3, un alkylidène contenant de 2 à 12 atomes de carbone, un cycloalkylidène contenant de 5 à 7 atomes de carbone, un radical $SiR_2^4$ ou un radical $SnR_2^4$, le symbole $R_4$ désignant un alkyle en $C_1$–$C_{12}$, un cycloalkyle en $C_5$–$C_{12}$, un aryle en $C_6$–$C_{16}$ ou un aralkyle en $C_7$–$C_{16}$,
les radicaux cyclopentadiényle$^\ominus$ et indényle$^\ominus$ ainsi que le radical de formule II pouvant chacun être dépourvus de substituants ou porter un alkyle linéaire ou ramifié, un alcoxy, un alcényle, un cycloalkyle, un cycloalcényle, un aryle, un aralkyle, un cyano, un halogène, un amino, un aminoalkyle, un amino quaternisé ou un aminoalkyle quaternisé,

$R^2$ représente un noyau aromatique carbocyclique hexagonal ou hétérocyclique pentagonal ou hexagonal, qui, en au moins l'une des deux positions ortho par rapport à la liaison métal-carbone, porte un atome de fluor, ou $R^2$ et $R^3$ forment ensemble un radical répondant à la formule III:

$$-Q-Y-Q- \qquad (III)$$

dans laquelle:

Q représente un noyau aromatique carbocyclique ou hétérocyclique contenant 5 ou 6 maillons, les deux liaisons à l'atome de titane étant chacune en position ortho par rapport à Y, et, sur chacun des deux noyaux, l'autre position ortho portant un

atome de fluor, les noyaux carbocycliques et hétérocycliques $R^2$ et Q portant éventuellement, comme substituants supplémentaires, un alkyle linéaire ou ramifié, un alcoxy, un cycloalkyle, un aryle, un aralkyle, un hydroxy, un carboxy, un cyano, un halogène, un alcoxycarbonyle, un amino-carbonyle, un amino, un amino quaternisé, un amino-alkyle ou un amino-alkyle quaternisé, et

Y représente $CH_2$, un alkylidène en $C_2$–$C_{12}$, un cyclo-alkylidène en $C_5$–$C_7$, une liaison directe, $NR^4$ O, S, SO, $SO_2$, CO, $SiR_2{}^4$ ou $SnR_2{}^4$,
et

$R^3$ représente un alcynyle, un phénylalcynyle non substitué ou porteur d'un halogène, d'un amino tertiaire, d'un alkyle en $C_1$–$C_6$, d'un alcoxy en $C_1$–$C_6$, d'un carboxy, d'un hydroxy ou d'un cyano, $N_3$, CN, $SiR_3{}^4$ ou $SnR_3{}^4$, ou a la signification de $R_2$.

8. Composition selon la revendication 7 dans laquelle le composé (a) est choisi dans l'ensemble constitué par les esters et les amides d'acides carboxyliques insaturés, les polyesters, les polyamides et les polyuréthannes insaturés, le polybutadiène, les copolymères du polybutadiène, le poly-isoprène et les copolymères du poly-isoprène.

9. Composition selon la revendication 7 dans laquelle le composé (a) est un ester acrylique ou méthacrylique d'un polyol organique.

10. Composition selon la revendication 7 qui contient un composé de formule I dans laquelle $R^1$ représente un radical cyclopentadiényle$^{\ominus}$ non substitué ou porteur d'un alkyle en $C_1$–$C_4$, et $R^2$ et $R^3$ représentent chacun un radical répondant à la formule:

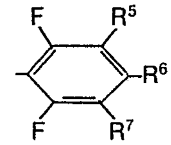

dans laquelle $R^5$, $R^6$ et $R^7$ représentent chacun, indépendamment les uns des autres, un atome d'hydrogène, F, Cl, Br, un radical amino tertiaire, un radical ammonium quaternaire, un radical aminoalkyle tertiaire ou un radical ammonio-alkyle quaternaire.

11. Composition selon la revendication 10 dans laquelle $R^5$, $R^6$ et $R^7$ représentent chacun F.

12. Substrat revêtu qui comporte, comme couche photopolymérisable, une composition selon la revendication 7.

13. Procédé pour créer des images photographiques en relief, procédé caractérisé en ce qu'on irradie conformément à une image un substrat revêtu selon la revendication 12 et on élimine ensuite au moyen d'un solvant les parties qui n'ont pas été touchées par le rayonnement.

14. Application de titanocènes de formule I selon la revendication 7 comme photo-amorceurs pour la photo-polymérisation de composés éthyléniques.